# EUROPÄISCHE PATENTSCHRIFT

(11) **EP 3 884 742 B1**
(45) Veröffentlichungstag und Bekanntmachung des Hinweises auf die Patenterteilung: **02.11.2022**
(21) Anmeldenummer: 19829554.5
(22) Anmeldetag: 19.12.2019
(51) Int. Cl.: H05K 7/14

(54) **BASISMODUL UND FUNKTIONSMODUL FÜR EIN SCHALTSCHRANKSYSTEM**
BASE MODULE AND FUNCTIONAL MODULE FOR A SWITCH CABINET SYSTEM
MODULE DE BASE ET MODULE FONCTIONNEL POUR UN SYSTÈME D'ARMOIRE DE DISTRIBUTION

(30) Priorität: 28.12.2018 DE 102018133646
(43) Veröffentlichungstag der Anmeldung: 29.09.2021
(73) Patentinhaber: Beckhoff Automation GmbH, 33415 Verl (DE)
(72) Erfinder: BECKHOFF, Hans, 33415 Verl (DE)
(74) Vertreter: Patentanwaltskanzlei WILHELM & BECK
(86) Internationale Anmeldenummer: PCT/EP2019/086344
(87) Internationale Veröffentlichungsnummer: WO 2020/136081

(56) Entgegenhaltungen:
- EP-A1- 2 986 093
- EP-A2- 2 793 540
- DE-A1- 19 748 531
- DE-A1-102006 062 044
- DE-A1-102011 110 184
- DE-A1-102013 112 101

## Beschreibung

Die Erfindung betrifft ein Basismodul für ein Schaltschranksystem. Ferner betrifft die Erfindung ein Schaltschranksystem aus Basismodul und einem oder mehreren Funktionsmodulen.

Diese Patentanmeldung nimmt die Priorität der deutschen Patentanmeldung 10 2018 133 646.2 vom 28.12.2018 in Anspruch, deren Inhalt durch Rückbezug vollumfänglich aufgenommen wird.

In modular aufgebauten Feldbussystemen, die beispielsweise in Automatisierungssystemen zum Einsatz kommen können, können Funktionsmodule direkt miteinander verbunden werden oder jeweils mit einem Basismodul verbunden werden. In der letzteren Variante können Datenanschlüsse und Kleinspannungsanschlüsse am Basismodul bereitgestellt sein, mit denen die Funktionsmodule verbunden werden. Dadurch ist ein einfacher Aufbau des modularen Feldbussystems möglich. Die Funktionsmodule können dabei verschiedene Funktionalitäten übernehmen und beispielsweise als Eingangsmodule, Ausgangsmodule, SPS-Steuerungsmodule, Motorsteuerungsmodule oder Netzteilmodule ausgestaltet sein. Über einen Feldbus wird sowohl eine Kommunikationsmöglichkeit als auch eine Spannungsversorgung mit einer Kleinspannung bereitgestellt. Ein solches Feldbussystem ist in der Druckschrift DE 100 06 879 A1 offenbart. Die Kommunikationsmöglichkeit und die Spannungsversorgung können auch mittels voneinander getrennten Anschlüssen bereitgestellt werden.

Nachteilig an diesem Feldbussystem ist also, dass für Funktionsmodule wie beispielsweise eine Motorsteuerung, für die eine höhere Spannung notwendig ist, ein eigener Netzanschluss bereitgestellt werden muss. Dadurch ist die Verkabelung und Installation eines solchen Feldbussystems kompliziert, wenn durch das Feldbussystem die Funktionalität eines Schaltschranks bereitgestellt werden soll. Ein Schaltschrank kann dabei die elektrischen und elektronischen Komponenten einer verfahrenstechnischen Anlage, einer Werkzeugmaschine oder Fertigungseinrichtung beinhalten, die sich nicht direkt in der Maschine befinden (siehe http://de.wikipe-dia.org/wiki/Schaltschrank) .

Die Druckschrift DE 10 2011 110 184 A1 offenbart eine modulare Steuervorrichtung, bei dem mehrere zweite Modulteile ein Basismodul bilden und bei dem mehrere erste Modulteile in das Basismodul einsteckbar sind.

Die Druckschrift EP 2 986 093 A1 offenbart ein industrielles Steuerungssystem mit einer Trennung von Daten- und Kleinspannungsleitungen auf einer ersten Leiterkarte und Niederspannungsleitungen auf einer zweiten Leiterkarte.

Die Druckschrift DE 10 2013 112 101 A1 offenbart ein Komponentenaufbausystem mit mehreren an einer Schiene anbringbaren Modulen.

Die Druckschrift DE 10 2006 062 044 A1 offenbart ein Druckausgleichselement für ein Gehäuse.

Die Druckschrift DE 197 48 531 A1 offenbart ein Aufbausystem für Verbraucherabzweige.

Die Druckschrift EP 2 793 540 A2 offenbart eine Motorsteuerung.

Eine Aufgabe der vorliegenden Erfindung ist es, ein Basismodul für ein Schaltschranksystem bereitzustellen, mit denen die Funktionalitäten eines Schaltschrankes bereitgestellt werden können. Ferner ist es eine Aufgabe der vorliegenden Erfindung, ein Schaltschranksystem aus Basismodul und einem oder mehreren Funktionsmodulen bereitzustellen.

Diese Aufgaben werden durch das Basismodul und das Schaltschranksystem der unabhängigen Patentansprüche gelöst. Weiterbildungen sind in den abhängigen Ansprüchen angegeben. Dabei kann es vorgesehen sein, dass das Schaltschranksystem den Normen EN60204 und/oder UL508 entspricht.

Ein Basismodul für ein Schaltschranksystem weist ein Gehäuse mit einer ersten Gehäuseseite und weiteren Gehäuseseiten auf. Die erste Gehäuseseite weist ein Raster von Öffnungen auf. Zusätzlich weist das Gehäuse Anschlusselemente für Funktionsmodule auf, die jeweils im Bereich der Öffnungen der ersten Gehäuseseite angeordnet sind. Die Anschlusselemente umfassen Datenanschlüsse, Kleinspannungsanschlüsse und Niederspannungsanschlüsse. Die Datenanschlüsse sind mittels einer Datenleitung des Basismoduls miteinander verbunden, wobei ein Feldbusanschluss für die Datenleitung bereitgestellt werden kann und wobei die Datenleitung innerhalb des Gehäuses angeordnet ist. Ferner ist jeweils eine Kleinspannungsleitung und Niederspannungsleitung innerhalb des Gehäuses angeordnet, wobei die Kleinspannungsleitung mit den Kleinspannungsanschlüssen verbunden ist und die Niederspannungsleitung mit den Niederspannungsanschlüssen verbunden ist. Ferner sind zwei Kanäle innerhalb des Gehäuses angeordnet, die durch eine erste Trennwand voneinander getrennt sind. Die Datenanschlüsse und die Kleinspannungsanschlüsse sind in einem ersten Kanal angeordnet, die Niederspannungsanschlüsse sind in einem zweiten Kanal angeordnet. Insbesondere kann eine erste Leiterkarte mit den Datenanschlüssen und den Kleinspannungsanschlüssen im ersten Kanal angeordnet sein, während eine zweite Leiterkarte mit den Niederspannungsanschlüssen im zweiten Kanal angeordnet sein kann. Die erste Leiterkarte kann dabei als Daten- und Kleinspannungsleiterkarte bezeichnet werden. Die zweite Leiterkarte kann als Niederspannungsleiterkarte bezeichnet werden.

Über die Datenanschlüsse kann ein Feldbus bereitgestellt werden, der der Kommunikation zwischen Basismodul und Funktionsmodulen dienen kann. Der Feldbus kann dabei als ein in der Norm IEC 61158 definierter Feldbus, insbesondere als EtherCAT oder EtherCAT P, ausgestaltet sein.

Kleinspannungen sind dabei elektrische Spannungen bis zu 50 Volt Wechselspannung und/oder 120 Volt Gleichspannung, insbesondere bis zu 25 Volt Wechselspannung und/oder 60 Volt Gleichspannung. Diese Definition einer Kleinspannung kann der Norm IEC60449 entnommen werden. Niederspannungen sind dabei elektrische Spannungen oberhalb der Kleinspannung und bis zu 1000 Volt Wechselspannung und/oder 1500 Volt Gleichspannung. Ferner kann vorgesehen sein, eine Versorgungsspannung für Kommunikationselektronik mittels der Datenleitung bereitzustellen. Diese Versorgungsspannung kann im Bereich einiger Volt liegen.

Eine maximale Stromstärke, die über die Kleinspannungsanschlüsse bereitgestellt werden kann, kann 40 Ampere betragen. Eine maximale Stromstärke, die über die Niederspannungsanschlüsse bereitgestellt werden kann, kann 75 Ampere betragen.

Durch die Niederspannungsleitung und Niederspannungsanschlüsse kann eine Niederspannung für die Funktionsmodule bereitgestellt werden. Dadurch können die Funktionalitäten, die traditionell mittels eines Schaltschranks bereitgestellt werden, mit einem solchen Basismodul und zugehörigen Funktionsmodulen bereitgestellt werden. Weitere Vorteile stellen der verminderte Verkabelungsaufwand und die einfachere Planung beziehungsweise Konzeptionierung eines solchen Schaltschranksystems dar.

Die jeweils im Bereich der Öffnungen der ersten Gehäuseseite angeordneten Anschlusselemente können innerhalb des Gehäuses angeordnet und durch die Öffnungen zugänglich für Modulanschlusselemente sein. Alternativ können die Anschlusselemente auch durch die Öffnungen geführt sein und außerhalb des Gehäuses angeordnet sein. Ferner können die Öffnungen durch die Anschlusselemente verschlossen sein, so dass die Öffnungen Durchbrüche durch die erste Gehäuseseite bilden, wobei die Anschlusselemente durch die Durchbrüche geführt sind und diese verschließen.

Das Gehäuse kann dabei als Stangenpressprofil oder als Druckgussgehäuse ausgeführt sein. Als Gehäusematerial kommen Metalle wie beispielsweise Aluminium, Stahl, Edelstahl oder Zink in Frage, wobei zusätzlich eine Beschichtung des Gehäuses vorgesehen sein kann. Alternativ kann das Gehäuse auch aus Kunststoff gefertigt sein.

Das Gehäuse kann dabei aus mehreren Einzelteilen bestehen, die mittels Befestigungselementen, beispielsweise Schrauben, oder mittels verschweißen oder verlöten miteinander verbunden werden. Ferner kann eine Abdichtung zwischen den Einzelteilen vorgesehen sein, um das Gehäuse zwischen den Einzelteilen für Flüssigkeiten und/oder Berührungen unzugänglich zu machen.

Die Datenleitung, die Kleinspannungsleitung und die Niederspannungsleitung können innerhalb des Gehäuses auf einer oder mehreren Leiterkarten angeordnet sein. Insbesondere kann eine Leiterkarte für die Datenleitung und die Kleinspannungsleitung und eine weitere Leiterkarte für die Niederspannungsleitung vorgesehen sein. Die Datenleitung kann mehrere Adern aufweisen. Die Kleinspannungsleitung kann mehrere Adern aufweisen. Die Niederspannungsleitung kann mehrere Adern aufweisen. Wenn die Datenleitung, Kleinspannungsleitung beziehungsweise Niederspannungsleitung auf einer Leiterkarte angeordnet ist, können die Aderns als Leiterbahnen auf der jeweiligen Leiterkarte ausgeführt sein. Ferner können Nuten auf einer oder mehreren Innenseiten des Gehäuses angeordnet sein, in die die Leiterkarten eingeschoben werden können. Alternativ oder zusätzlich können die Leiterkarten mit dem Gehäuse verschraubt sein.

Ein Funktionsmodul weist ein Modulgehäuse, eine elektronische Schaltung und ein Modulanschlusselement auf. Das Modulanschlusselement ist eingerichtet, in Anschlusselemente des Basismoduls, insbesondere in die Datenanschlüsse und die Kleinspannungsanschlüsse, einzugreifen. Das Modulgehäuse weist eine erste Modulgehäuseseite und weitere Modulgehäuseseiten auf. Es kann vorgesehen sein, dass die erste Modulgehäuseseite eine Modulgehäuseöffnung aufweist, durch die das Modulgehäuse zugänglich ist. Ferner kann vorgesehen sein, dass die erste Modulgehäuseseite eben ist. Insbesondere kann ein metallisches Bauteil des Modulgehäuses die ebene erste Modulgehäuseseite mit der Modulgehäuseöffnung aufweisen.

Die Anschlusselemente beziehungsweise das Modulanschlusselement können dabei als Steckverbinder ausgestaltet sein, insbesondere können die Anschlusselemente als Buchse und das Modulanschlusselement als Stecker ausgestaltet sein oder umgekehrt.

Alternativ können die Anschlusselemente eine Kabeleinführung und einen Klemmanschluss aufweisen.

Ein Schaltschranksystem besteht aus einem Basismodul und mindestens einem Funktionsmodul, wobei das Funktionsmodul an der ersten Gehäuseseite des Basismoduls angeordnet werden kann. Das Funktionsmodul deckt mindestens eine der Öffnungen des Gehäuses des Basismoduls ab.

Mittels mehrerer Funktionsmodule kann die Funktionalität eines Schaltschranks bereitgestellt werden, wobei die Funktionsmodule nicht unmittelbar miteinander verbunden werden, sondern eine Verbindung der Funktionsmodule über das Basismodul bereitgestellt wird.

In einer Ausführungsform des Basismoduls sind jeweils eine Mehrzahl von Datenanschlüssen und eine Mehrzahl von Kleinspannungsanschlüssen auf einer Daten- und Kleinspannungsleiterkarte angeordnet. Eine Mehrzahl von Niederspannungsanschlüssen ist auf einer Niederspannungsleiterkarte angeordnet. Die Datenleitung und die Kleinspannungsleitung werden durch die Daten- und Kleinspannungsleiterkarte bereitgestellt. Die Niederspannungsleitung wird durch die Niederspannungsleiterkarte bereitgestellt.

Es kann vorgesehen sein, dass alternativ zu den Niederspannungsanschlüssen oder zusätzlich zu den Niederspannungsanschlüssen auch Datenanschlüsse und Kleinspannungsanschlüsse im zweiten Kanal angeordnet sind. Dies kann ebenfalls dadurch erfolgen, dass im zweiten Kanal eine Daten- und Kleinspannungsleiterkarte angeordnet wird.

In einer Ausführungsform des Basismoduls weist das Gehäuse einen dritten Kanal auf, der mittels einer zweiten Trennwand vom ersten beziehungsweise zweiten Kanal getrennt ist. Über den dritten Kanal kann Kühlluft geführt werden. Ferner kann zusätzlich eine weitere Leiterkarte im dritten Kanal bereitgestellt werden.

Alternativ oder zusätzlich können im dritten Kanal auch Datenanschlüsse und/oder Kleinspannungsanschlüsse und/oder Niederspannungsanschlüsse vorgesehen sein. Dies können ebenfalls mittels Daten- und Kleinspannungsleiterkarte beziehungsweise Niederspannungsleiterkarte bereitgestellt werden.

Durch die Kanäle kann ein systematischer Aufbau des Basismoduls erfolgen und verschiedene Funktionalitäten des Basismoduls verschiedenen Kanälen zugeordnet werden.

In einer Ausführungsform des Basismoduls ist die erste Gehäuseseite eben. Dies ermöglicht, Funktionsmodule, die ebenfalls eben sind, einfach am Basismodul anzubringen und dadurch ein einfach aufzubauendes Schaltschranksystem bereitzustellen.

In einer Ausführungsform des Basismoduls weisen die Niederspannungsanschlüsse jeweils einen siebenpoligen Steckverbinder auf, der als Stecker oder als Buchse ausgeführt sein kann. Das zugehörige Modulanschlusselement des Funktionsmoduls kann dann als Buchse oder Stecker ausgeführt sein. Der siebenpolige Steckverbinder weist einen ersten Kontakt, einen zweiten Kontakt und einen dritten Kontakt für jeweils eine Wechselstromphase, einen vierten Kontakt für einen Wechselstromneutralleiter, einen fünften Kontakt für einen Schutzleiter, sowie einen sechsten Kontakt und einen siebten Kontakt für eine Gleichspannung auf. Ein Modulanschlusselement kann als fünfpoliger Steckverbinder mit einem achten Kontakt, einem neunten Kontakt und einem zehnten Kontakt für jeweils eine der drei Wechselstromphasen, einem elften Kontakt für den Wechselstromneutralleiter und einem zwölften Kontakt für den Schutzleiter ausgeführt sein. Zusätzlich kann das Modulanschlusselement einen dreizehnten Kontakt und einen vierzehnten Kontakt für die Gleichspannung aufweisen und ist dann als siebenpoliger Steckverbinder ausgeführt. Alternativ kann das Modulanschlusselement nur den zwölften Kontakt für den Schutzleiter sowie den dreizehnten Kontakt und den vierzehnten Kontakt für die Gleichspannung aufweisen und ist dann als dreipoliger Steckverbinder ausgeführt.

Dadurch kann auf der Seite des Basismoduls ein universeller Steckverbinder bereitgestellt werden. Das Modulanschlusselement wird derart ausgebildet, dass in die Kontakte für die Wechselspannung und/oder in die Kontakte für die Gleichspannung eingegriffen werden kann, je nachdem ob das Funktionsmodul Gleichspannung, Wechselspannung oder sowohl Gleichspannung als auch Wechselspannung benötigt.

In einer Ausführungsform des Basismoduls sind die Datenanschlüsse und Kleinspannungsanschlüsse unterhalb der Öffnungen innerhalb des Gehäuses angeordnet. Dadurch können unabsichtliche Berührungen der Datenanschlüsse und Kleinspannungsanschlüsse zum Teil vermieden werden.

In einer Ausführungsform des Basismoduls weist dieses eine Sicherheitsschaltung auf. Die Sicherheitsschaltung ist zur Abschaltung eines der Kleinspannungsanschlüsse und/oder eines der Niederspannungsanschlüsse eingerichtet. Die Sicherheitsschaltung kann dazu mit der Datenleitung verbunden sein und auf den Feldbus zugreifen. Dadurch können auch sicherheitsrelevante Funktionen mittels des Schaltschranksystems aus Basismodul und Funktionsmodul gesteuert werden. Sicherheitsrelevante Funktionen können beispielsweise ein sicheres Stillsetzen von Antrieben mit entsprechenden STO (Safe Torque Off) zertifizierten Eingängen, ein zweikanaliges Abschalten von 24VDC Aktoren und/oder ein zweikanaliges Abschalten von zwangsöffnenden Relais umfassen.

In einer Ausführungsform des Basismoduls weist dieses eine Überwachungsschaltung auf. Die Überwachungsschaltung ist zur Ermittlung eines Umgebungsparameters, insbesondere einer Neigung und/oder einer Schwingung, eingerichtet. Ferner ist die Überwachungsschaltung zur Abschaltung eines der Kleinspannungsanschlüsse und/oder eines der Niederspannungsanschlüsse eingerichtet, sofern der Umgebungsparameter außerhalb eines vorbestimmten Wertebereichs liegt. Insbesondere kann die Überwachungsschaltung zur Abschaltung aller Kleinspannungsanschlüsse und/oder Niederspannungsanschlüsse eingerichtet sein. Alternativ kann die Überwachungsschaltung zur Ausgabe einer Warnmeldung eingerichtet sein, wenn eine über die Neigung ermittelte Einbaulage nicht konform mit Einbauspezifikationen ist. Alternativ oder zusätzlich kann die Sicherheitsschaltung zur Abschaltung eines der Kleinspannungsanschlüsse und/oder eines der Niederspannungsanschlüsse, insbesondere aller Kleinspannungsanschlüsse und/oder Niederspannungsanschlüsse eingerichtet sein, wenn eine über die Neigung ermittelte Einbaulage nicht konform mit Einbauspezifikationen ist. Dadurch kann der Betrieb des Basismoduls innerhalb sicherer Betriebsparameter ermöglicht werden, wobei außerhalb der sicheren Betriebsparameter eine Abschaltung des Basismoduls erfolgt. Ein alternativer oder zusätzlicher Umgebungsparameter kann eine Temperatur sein, wodurch das Basismodul gegen Überhitzung geschützt werden kann. Ein weiterer alternativer oder zusätzlicher Umgebungsparameter kann eine Luftfeuchtigkeit sein, wodurch das Basismodul gegen Spannungsüberschläge geschützt werden kann.

In einer Ausführungsform des Basismoduls weist dieses Gehäuseanschlüsse für Daten und/oder zumindest eine Kleinspannung und/oder zumindest eine Niederspannung auf. Dabei kann vorgesehen sein, dass der Gehäuseanschluss für Daten mit der Datenleitung, des Gehäuseanschluss für Kleinspannung mit der Kleinspannungsleitung und/oder der Gehäuseanschluss für Niederspannung mit der Niederspannungsleitung verbunden sind. Der oder die Gehäuseanschlüsse können an der ersten Gehäuseseite oder an einer weiteren Gehäuseseite angeordnet sein. Die Gehäuseanschlüsse können dadurch als Einspeiseanschlüsse für Daten, Kleinspannung oder Niederspannung dienen. Alternativ kann die Einspeisung über ein entsprechendes Funktionsmodul, welches als Einspeisemodul ausgestaltet ist, erfolgen.

Ferner können weitere Gehäuseanschlüsse für Daten und/oder eine Kleinspannung und/oder eine Niederspannung vorgesehen sein, die zur Weiterleitung von Daten, Kleinspannung oder Niederspannung in ein weiteres Basismodul dienen können. Alternativ kann auch die Weiterleitung über ein entsprechendes Funktionsmodul, welches als Weiterleitungsmodul ausgestaltet ist, erfolgen. Mittels des Weiterleitungsmoduls können die Daten, die Kleinspannung und/oder die Niederspannung von einem ersten Basismodul an ein zweites Basismodul weitergegeben werden. Dies ist insbesondere vorteilhaft, wenn ein Basismodul nicht genügend Anschlusselemente für alle benötigten Funktionalitäten aufweist. Mittels des Weiterleitungsmoduls kann ein Schaltschranksystem aus Basismodulen und Funktionsmodulen also modular erweiterbar ausgestaltet werden.

Insbesondere kann vorgesehen sein, das erste Basismodul mit einem Weiterleitungsmodul auszustatten und das zweite Basismodul mit einem Einspeisemodul auszustatten, und das Weiterleitungsmodul und das Einspeisemodul mit einer externen Datenleitung, die als Feldbusleitung ausgestaltet sein kann, einer externen Kleinspannungsleitung und einer externen Niederspannungsleitung zu verbinden. Dadurch können mehrere Funktionsmodule in das Schaltschranksystem integriert werden. Die Anzahl der Basismodule innerhalb des Schaltschranksystems kann durch maximale Ströme und/oder maximale Leitungslängen begrenzt sein.

In einer Ausführungsform des Basismoduls weist dieses eine Dichtung auf, die umlaufend um eine Öffnung oder umlaufend um mehrere Öffnungen angeordnet ist. Durch die Dichtung kann eine Abdichtung des Schaltschranksystems aus Basismodul und Funktionsmodulen erreicht werden, wodurch dem Schaltschranksystem aus Basismodul und Funktionsmodulen eine sogenannte IP Schutzklasse zugeordnet werden kann, beispielsweise IP67. Alternativ oder zusätzlich kann auch eine an den Funktionsmodulen angeordnete Dichtung vorgesehen sein.

In einer Ausführungsform des Basismoduls weist das Gehäuse eine Druckausgleichsmembran auf. Dadurch kann ein Luftdruck innerhalb des Gehäuses an einen Luftdruck außerhalb des Gehäuses angeglichen werden, ohne das Gehäuse undicht für Flüssigkeiten und/oder Staub zu machen.

In einer Ausführungsform des Basismoduls weist dieses eine Erdungsschiene auf. Die Erdungsschiene kann dabei als Funktionserde für an die Funktionsmodule angeschlossene weitere Komponenten dienen. Ferner kann die Erdungsschiene mit einer Funktionserde der Kleinspannungsleitung und/oder Niederspannungsleitung verbunden sein.

In einer Ausführungsform des Funktionsmoduls weist das Modulgehäuse eine erste Modulgehäuseseite und weitere Modulgehäuseseiten auf. Die erste Modulgehäuseseite weist eine Modulgehäuseöffnung auf und ist eben. Insbesondere kann ein metallisches Bauteil des Modulgehäuses die ebene erste Modulgehäuseseite mit der Modulgehäuseöffnung aufweisen. In einer Ausführungsform des Funktionsmoduls ist das Modulanschlusselement ferner eingerichtet, in die Niederspannungsanschlüsse einzugreifen.

In einer Ausführungsform des Schaltschranksystems sind mehrere Funktionsmodule am Basismodul befestigt. Die Funktionsmodule decken die Öffnungen des Gehäuses ab. Dabei ist das Schaltschranksystem staubdicht und wasserdicht, beispielsweise nach IP67, ausgeführt. Die Abdichtung des Schaltschranksystems kann dabei mittels zumindest einer Dichtung am Basismodul und/oder zumindest einer Dichtung am Funktionsmodul erreicht werden.

Die Erfindung wird nachfolgend anhand von Ausführungsbeispielen und unter Bezugnahme auf Figuren näher erläutert. Dabei zeigen jeweils in schematischer Darstellung
- Fig. 1: eine isometrische Ansicht eines Basismoduls;
- Fig. 2: eine Draufsicht auf das Basismodul;
- Fig. 3: eine Draufsicht auf ein weiteres Basismodul;
- Fig. 4: einen Querschnitt des weiteren Basismoduls;
- Fig. 5: eine Draufsicht auf ein weiteres Basismodul;
- Fig. 6: einen Querschnitt des weiteren Basismoduls;
- Fig. 7: einen ersten Steckverbinder des Niederspannungsanschlusses;
- Fig. 8: einen zweiten Steckverbinder des Niederspannungsanschlusses;
- Fig. 9: einen Querschnitt eines weiteren Basismoduls;
- Fig. 10: einen Querschnitt eines weiteren Basismoduls;
- Fig. 11: einen Querschnitt eines weiteren Basismoduls;
- Fig. 12: eine weitere Gehäuseseite eines Basismoduls;
- Fig. 13: eine Draufsicht auf ein weiteres Basismodul;
- Fig. 14: einen Querschnitt durch ein Schaltschranksystem aus Basismodul und Funktionsmodul;
- Fig. 15: einen weiteren Querschnitt durch das Schaltschranksystem;
- Fig. 16: einen Querschnitt durch ein weiteres Schaltschranksystem aus Basismodul und Funktionsmodul;
- Fig. 17: ein erstes Befestigungsmittel;
- Fig. 18: eine isometrische Ansicht des Schaltschranksystems;
- Fig. 19: eine Draufsicht auf ein weiteres Schaltschranksystem;
- Fig. 20: eine isometrische Ansicht eines weiteren Basismoduls;
- Fig. 21: eine isometrische Ansicht eines weiteren Schaltschranksystems;
- Fig. 22: einen Querschnitt des weiteren Schaltschranksystems;
- Fig. 23: einen weiteren Querschnitt des weiteren Schaltschranksystems;
- Fig. 24: einen weiteren Querschnitt des weiteren Schaltschranksystems;
- Fig. 25: eine isometrische Ansicht des weiteren Schaltschranksystems;
- Fig. 26: einen Querschnitt eines weiteren Schaltschranksystems;
- Fig. 27: einen weiteren Querschnitt des weiteren Schaltschranksystems;
- Fig. 28: einen weiteren Querschnitt des weiteren Schaltschranksystems; und
- Fig. 29: eine Ansicht des weiteren Schaltschranksystems.

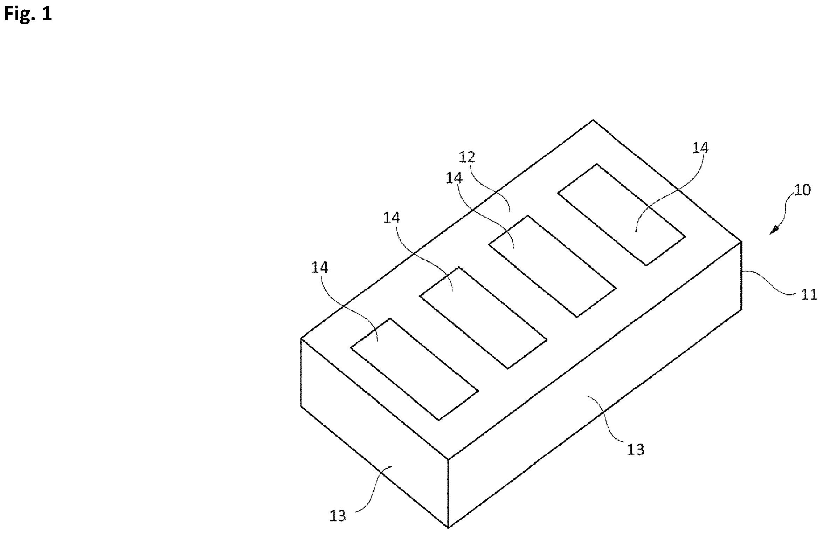

Fig. 1 zeigt eine isometrische Ansicht eines Basismoduls 10. Das Basismodul 10 weist ein Gehäuse 11 mit einer ersten Gehäuseseite 12 und weiteren Seitenwänden 13 auf. Die erste Gehäuseseite 12 weist ein Raster von Öffnungen 14 auf, hier vier nebeneinander liegende Öffnungen 14 in einer 1x4-Anordnung. Die Öffnungen 14 liegen also in einer Reihe. Es können auch mehrere Reihen von Öffnungen 14 sowie mehr oder weniger als vier Öffnungen 14 in einer Reihe vorgesehen sein. Die erste Gehäuseseite 12 kann, wie in Fig. 1 gezeigt, eben ausgeführt sein.

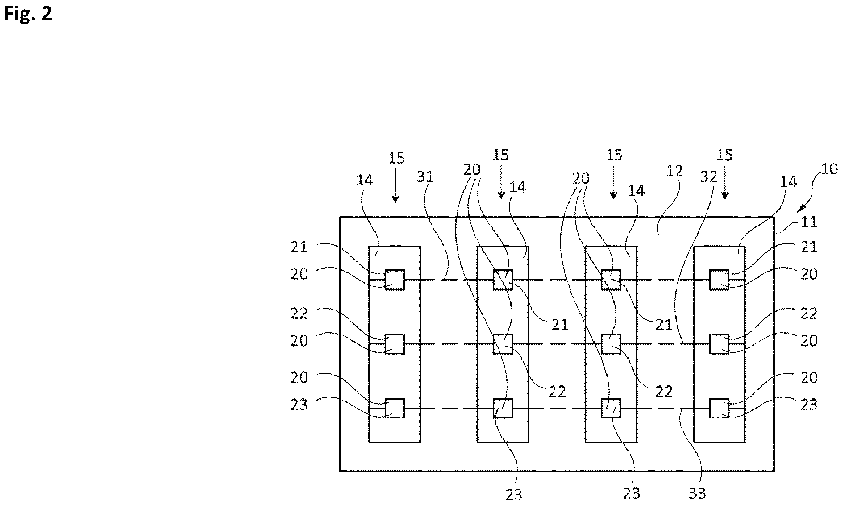

Fig. 2 zeigt eine Draufsicht auf die erste Gehäuseseite 12 des Basismoduls 10 der Fig. 1. Durch die Öffnungen 14 sind Anschlusselemente 20 zugänglich, wobei die Anschlusselemente 20 zum Anschluss von Funktionsmodulen an das Basismodul 10 geeignet sind. Die Anschlusselemente 20 sind im Bereich der Öffnungen 14 angeordnet. Die Anschlusselemente 20 umfassen Datenanschlüsse 21, Kleinspannungsanschlüsse 22 sowie Niederspannungsanschlüsse 23. Die Datenanschlüsse 21 sind über eine Datenleitung 31 miteinander verbunden. Ein Feldbus kann über die Datenleitung 31 bereitgestellt werden. Die Kleinspannungsanschlüsse 22 sind über eine Kleinspannungsleitung 32 miteinander verbunden. Die Niederspannungsanschlüsse 23 sind über eine Niederspannungsleitung 33 miteinander verbunden. Da die Datenleitung 31, die Kleinspannungsleitung 32 und die Niederspannungsleitung 33 außerhalb der Öffnungen 14 von der ersten Gehäuseseite 12 verdeckt sind, sind diese dort mittels gestrichelten Linien dargestellt.

Jede Öffnung 14 ist einem Steckplatz 15 zugeordnet. Die Steckplätze 15 sind zur Aufnahme von Funktionsmodulen eingerichtet. Jeder Steckplatz 15 weist jeweils einen Datenanschluss 21, einen Kleinspannungsanschluss 22 und einen Niederspannungsanschluss 23 auf. Funktionsmodule können dabei einen Steckplatz 15, aber auch mehrere Steckplätze 15 überdecken. Funktionsmodule, die mehrere Steckplätze 15 überdecken, können einerseits mehr Bauraum aufweisen, wodurch eine größere Breite des Funktionsmoduls notwendig wird. Andererseits können so auch zusätzliche Modulanschlüsse realisiert werden, indem beispielsweise in die Datenanschlüsse 21 zweier Steckplätze 15 eingegriffen wird.

Durch die Niederspannungsleitung 33 und Niederspannungsanschlüsse 23 kann eine Niederspannung für Funktionsmodule bereitgestellt werden. Dadurch können die Funktionalitäten, die traditionell mittels eines Schaltschranks bereitgestellt werden, mit einem solchen Basismodul 10 und zugehörigen Funktionsmodulen bereitgestellt werden.

Die Datenleitung 31, die Kleinspannungsleitung 32 und die Niederspannungsleitung 33 können jeweils zwei oder mehr Adern aufweisen, wobei in Fig. 2 und auch in den folgenden Figuren nur eine Linie gezeigt ist.

Die jeweils im Bereich der Öffnungen 14 der ersten Gehäuseseite 12 angeordneten Anschlusselemente 20 sind innerhalb des Gehäuses 11 angeordnet und durch die Öffnungen 14 zugänglich für Modulanschlusselemente. In Fig. 1 sind die Anschlusselemente, also Datenanschlüsse, Kleinspannungsanschlüsse sowie Niederspannungsanschlüsse, nicht dargestellt.

Das Gehäuse 11 kann dabei als Stangenpressprofil oder als Druckgussgehäuse ausgeführt sein. Als Gehäusematerial kommen Metalle wie beispielsweise Aluminium, Stahl, Edelstahl oder Zink in Frage, wobei zusätzlich eine Beschichtung des Gehäuses vorgesehen sein kann. Als alternatives Gehäusematerial kann Kunststoff zum Einsatz kommen.

Das Gehäuse 11 kann dabei aus mehreren Einzelteilen bestehen, die mittels Befestigungselementen, beispielsweise Schrauben, oder mittels verschweißen oder verlöten miteinander verbunden werden. Ferner kann eine Abdichtung zwischen den Einzelteilen vorgesehen sein, um das Gehäuse 11 zwischen den Einzelteilen für Wasser und/oder Berührungen unzugänglich zu machen.

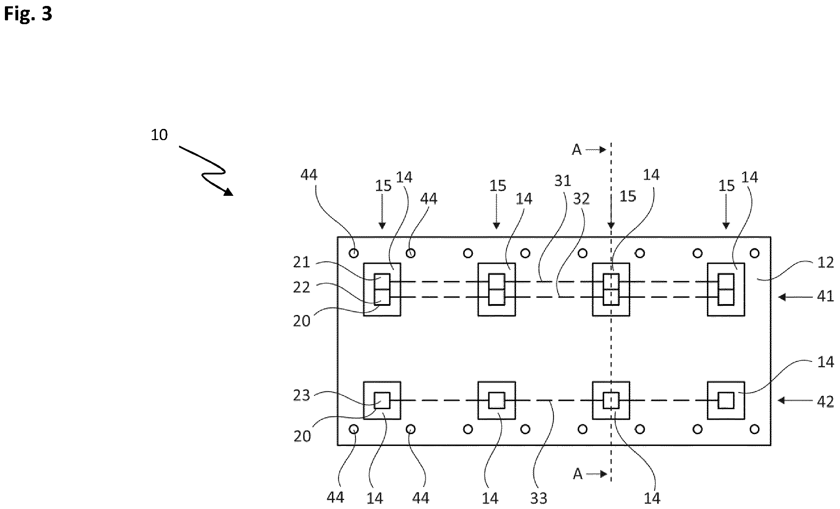

Fig.3 zeigt eine Draufsicht auf ein weiteres Basismodul 10, welches dem Basismodul der Fig. 1 und 2 entspricht, sofern im Folgenden keine Unterschiede beschrieben sind. Das Raster der Öffnungen 14 des Basismoduls 10 entspricht einer 2x4-Anordnung, wobei jeweils zwei Öffnungen 14 einem Steckplatz 15 zugeordnet sind. Ein kombiniertes Anschlusselement 20 umfasst den Datenanschluss 21 und den Kleinspannungsanschluss 22 und ist einer ersten Reihe 41 von Öffnungen 14 der 2x4-Anordnung zugeordnet. Ein weiteres Anschlusselement 20 stellt den Niederspannungsanschluss 23 bereit und ist einer zweiten Reihe 42 von Öffnungen 14 zugeordnet.

Jedem Steckplatz 15 sind außerdem vier Gewindelöcher 44 zugeordnet. Die Gewindelöcher 44 sind dabei als Sackloch ausgeführt. Funktionsmodule können mittels Schrauben an den Gewindelöchern 44 befestigt werden. Die Gewindelöcher 44 durchbrechen das Gehäuse 11 nicht, damit weder Wasser noch Staub über die Gewindelöcher 44 in das Innere des Gehäuses 11 gelangen können.

Eine Wandstärke des Gehäuses 11 kann dabei mehr als fünf Millimeter, insbesondere sieben oder mehr Millimeter betragen, damit die Gewindelöcher 44 tief genug für einen sicheren Halt einer Schraube sind, ohne das Gehäuse 11 durchbrechen zu müssen.

Es können auch mehr als vier Öffnungen 14 in einer Reihe 41, 42 des Rasters der Öffnungen 14 angeordnet sein, ebenso wie mehr als zwei Reihen von Öffnungen 14.

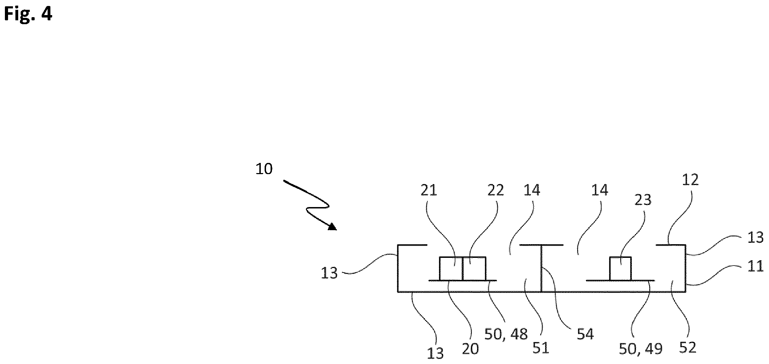

Fig. 4 zeigt einen Querschnitt durch das Basismodul 10 der Fig. 3 an der in Fig. 3 mit A markierten Stelle. Das Basismodul 10 weist im Inneren des Gehäuses 11 einen ersten Kanal 51 und einen zweiten Kanal 52 auf. Beide Kanäle 51, 52 sind jeweils durch eine Öffnung 14 zugänglich, wobei der Datenanschluss 21 und der Kleinspannungsanschluss 22 im ersten Kanal 51 und der Niederspannungsanschluss 23 im zweiten Kanal 52 angeordnet ist. Der erste Kanal 51 und der zweite Kanal 52 sind durch eine erste Trennwand 54 voneinander getrennt. Alle Datenanschlüsse 21 und alle Kleinspannungsanschlüsse 22 sind im ersten Kanal 51 und alle Niederspannungsanschlüsse 23 im zweiten Kanal 52 angeordnet. Die Datenanschlüsse 21 und Kleinspannungsanschlüsse 22 sind auf einer Leiterkarte 50, welche als Daten- und Kleinspannungsleiterkarte 48 ausgestaltet und im ersten Kanal 51 angeordnet ist, angeordnet. Die Daten- und Kleinspannungsleiterkarte 48 stellt auch die Datenleitung 31 und die Kleinspannungsleitung 32 bereit. Die Niederspannungsanschlüsse 23 sind auf einer Leiterkarte 50, welche als Niederspannungsleiterkarte 49 ausgestaltet und im zweiten Kanal 52 angeordnet ist, angeordnet. Die Niederspannungsleiterkarte 49 stellt die Niederspannungsleitung 33 bereit.

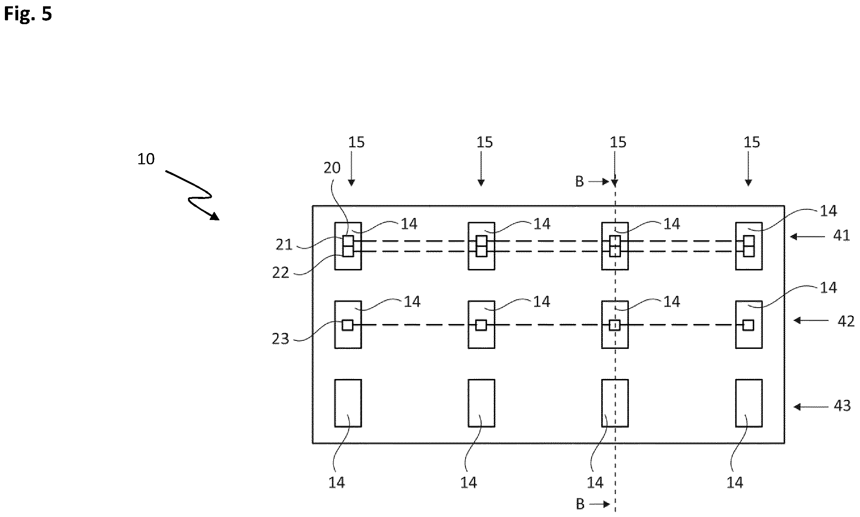

Fig.5 zeigt eine Draufsicht auf ein weiteres Basismodul 10, welches dem Basismodul der Fig. 3 und 4 entspricht, sofern im Folgenden keine Unterschiede beschrieben sind. Das Raster der Öffnungen 14 des Basismoduls 10 entspricht einer 3x4-Anordnung, wobei jeweils drei Öffnungen 14 einem Steckplatz 15 zugeordnet sind. Ein kombiniertes Anschlusselement 20 umfasst den Datenanschluss 21 und den Kleinspannungsanschluss 22 und ist einer ersten Reihe 41 von Öffnungen 14 der 3x4-Anordnung zugeordnet. Ein weiteres Anschlusselement 20 stellt den Niederspannungsanschluss 23 bereit und ist einer zweiten Reihe 42 von Öffnungen 14 der 3x4-Anordnung zugeordnet. Eine dritte Reihe 43 von Öffnungen weist kein Anschlusselement auf. Über die dritte Reihe 43 von Öffnungen kann beispielsweise Kühlluft für Funktionsmodule geführt werden. Alternativ ist es denkbar, dass auch in der dritten Reihe 43, analog zum ersten Kanal 41, kombinierte Anschlusselemente 20 mit jeweils einem Datenanschluss 21 und einem Kleinspannungsanschluss 22 und/oder analog zum zweiten Kanal 42, weitere Anschlusselemente 20 die jeweils einen Niederspannungsanschluss 23 bereitstellen, angeordnet sind.

In Fig. 5 sind keine Gewindelöcher 44 gezeigt. Diese können jedoch analog zu Fig. 3 vorgesehen sein, ebenso in den noch folgenden Ausführungsbeispielen. Dabei können vier Gewindelöcher 44 pro Steckplatz 15, aber auch vier Gewindelöcher 44 pro Öffnung 14 vorgesehen sein.

Es können auch mehr als vier Öffnungen 14 in einer Reihe 41, 42, 43 des Rasters der Öffnungen 14 angeordnet sein, ebenso wie mehr als drei Reihen von Öffnungen 14.

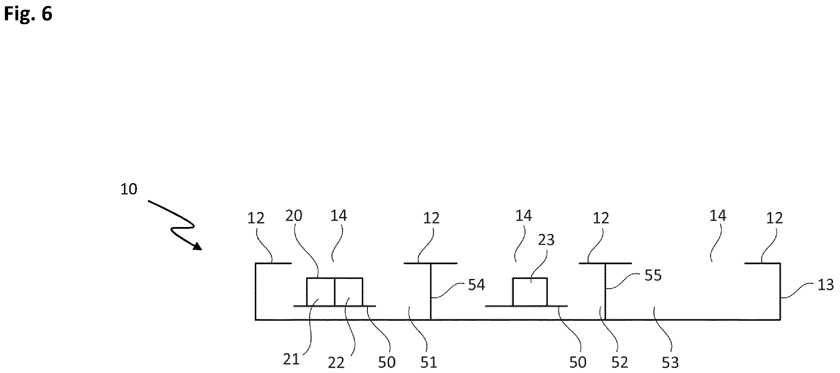

Fig. 6 zeigt einen Querschnitt durch das Basismodul 10 der Fig. 5 an der in Fig. 5 mit B markierten Stelle. Das Basismodul 10 weist im Inneren des Gehäuses 11 zusätzlich zum ersten Kanal 51 und zum zweiten Kanal 52 einen dritten Kanal 53 auf. Die Kanäle 51, 52, 53 sind jeweils durch eine Öffnung 14 zugänglich. Der zweite Kanal 52 und der dritte Kanal 53 sind durch eine zweite Trennwand 55 voneinander getrennt. Der dritte Kanal 53 kann insbesondere dafür verwendet werden, Kühlluft für Funktionsmodule bereitzustellen. Alternativ oder zusätzlich kann auch eine Leiterkarte mit Anschlusselementen im dritten Kanal 53 angeordnet werden, analog zu den im ersten Kanal 51 beziehungsweise zweiten Kanal 52 angeordneten Leiterkarten.

Das Material des Gehäuse 11 der Ausführungsbeispiele der Fig. 4 und 6 kann ein Metall aufweisen. Die Trennwände 54, 55 können dabei aus dem Material des Gehäuses 11 bestehen. Ebenso ist möglich, das Gehäuse 11 aus Metall und die Trennwände 54, 55 aus Kunststoff auszuführen oder das Gehäuse 11 aus Kunststoff und die Trennwände 54, 55 aus Metall auszuführen.

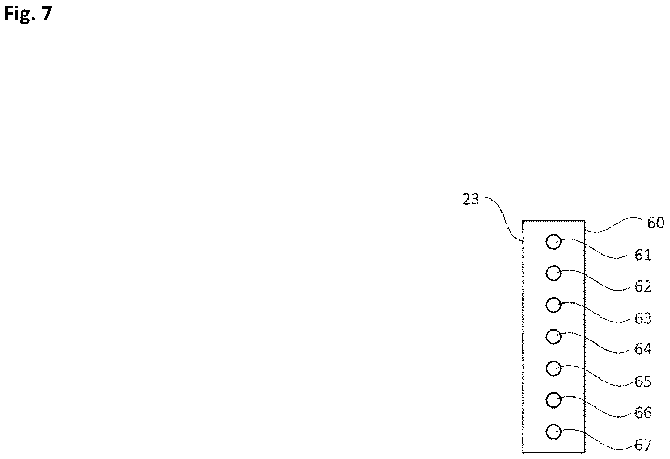

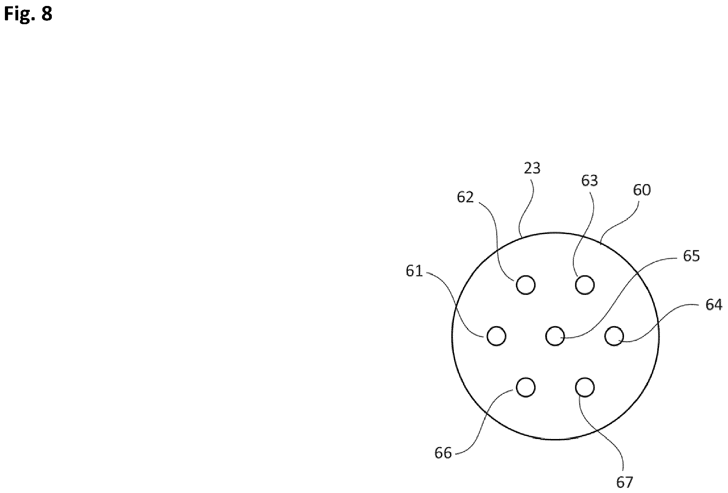

Fig. 7 und Fig. 8 zeigen jeweils ein Beispiel für einen siebenpoligen Steckverbinder 60, der als Buchse ausgestaltet sein kann und einen Niederspannungsanschluss 23 bildet. Der Steckverbinder 60 weist einen ersten Kontakt 61, einen zweiten Kontakt 62 und einen dritten Kontakt 63 für jeweils eine Wechselstromphase eines Dreiphasenwechselstroms auf. Ferner weist der Steckverbinder 60 einen vierten Kontakt 64 für einen Wechselstromneutralleiter, einen fünften Kontakt 65 für einen Schutzleiter sowie einen sechsten Kontakt 66 und einen siebten Kontakt 67 für eine Gleichspannung auf. Ein Funktionsmodul kann ein Modulanschlusselement aufweisen, das als Stecker ausgestaltet ist. Abhängig von der vom Funktionsmodul benötigten Spannungsversorgung kann der Stecker in den ersten Kontakt 61, den zweiten Kontakt 62, den dritten Kontakt 63, den vierten Kontakt 64 und den fünften Kontakt 65 eingreifen, wenn vom Funktionsmodul eine Dreiphasenwechselspannung benötigt wird. Wird nur eine Phase der Wechselspannung benötigt, kann neben dem vierten Kontakt 64 und dem fünften Kontakt 65 in den ersten Kontakt 61 oder den zweiten Kontakt 62 oder den dritten Kontakt 63 eingegriffen werden. Falls das Funktionsmodul eine Gleichspannung benötigt, kann in den fünften Kontakt 65, den sechsten Kontakt 66 sowie den siebten Kontakt 67 eingegriffen werden. Wenn sowohl Gleichspannung als auch Wechselspannung vom Funktionsmodul benötigt werden, kann ebenfalls in die entsprechenden Kontakte eingegriffen werden, insbesondere in alle ersten bis siebten Kontakte 61, 62, 63, 64, 65, 66, 67, falls alle drei Wechselstromphasen verwendet werden, oder in den vierten Kontakt 64, den fünften Kontakt 65, den sechsten Kontakt 66, den siebten Kontakt 67 sowie in den ersten Kontakt 61 oder den zweiten Kontakt 62 oder den dritten Kontakt 63, falls nur eine der drei Wechselstromphasen verwendet wird.

In Fig. 7 sind die ersten bis siebten Kontakte 61, 62, 63, 64, 65, 66, 67 in dieser Reihenfolge in einer Reihe angeordnet. Dadurch wird eine einfache Verschaltung der ersten bis siebten Kontakte 61, 62, 63, 64, 65, 66, 67 möglich. Ein Stecker eines Funktionsmodul kann in die ersten bis fünften Kontakte 61, 62, 63, 64, 65 oder in die fünften bis siebten Kontakte 65, 66, 67 eingreifen, um eine Wechselspannung beziehungsweise eine Gleichspannung für das Funktionsmodul bereitzustellen.

In Fig. 8 sind die ersten bis siebten Kontakte 61, 62, 63, 64, 65, 66, 67 in einem gleichseitigen Sechseck angeordnet, wobei der fünfte Kontakt 65 im Mittelpunkt des Sechsecks angeordnet ist. Dadurch wird eine kompakte Steckerbauform ermöglicht. Es sind jedoch auch alternative Anordnungen der ersten bis siebten Kontakte 61, 62, 63, 64, 65, 66, 67 möglich.

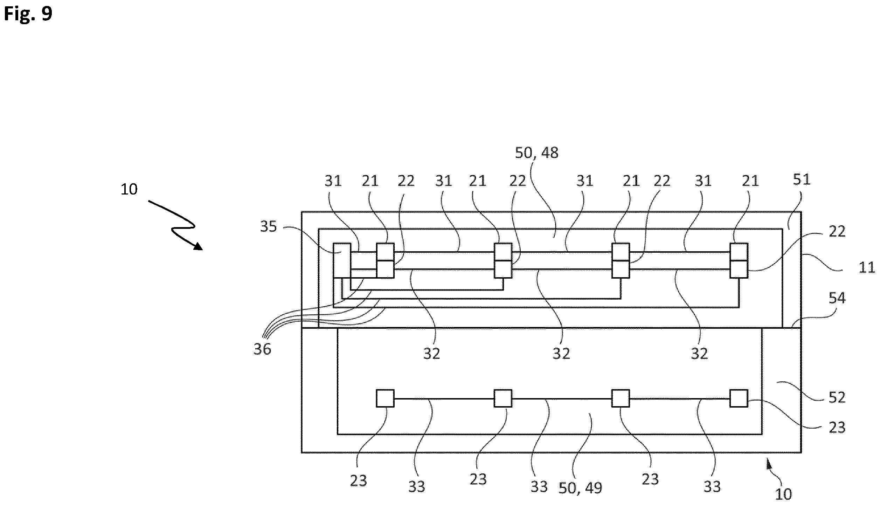

Fig. 9 zeigt eine Draufsicht auf ein geöffnetes Gehäuse 11 eines weiteren Basismoduls 10. Das Basismodul 10 ist identisch zum Basismodul 10 der Fig. 3 und 4 aufgebaut, sofern im Folgenden keine Unterschiede beschrieben sind. Die Daten- und Kleinspannungsleiterkarte 48 im ersten Kanal 51 weist eine Sicherheitsschaltung 35 auf. Die Sicherheitsschaltung 35 ist mit einer Datenleitung 31 mit den Datenanschlüssen 21 verbunden. Ferner sind Sicherheitsleitungen 36 zwischen der Sicherheitsschaltung 35 und den Kleinspannungsanschlüssen 22 angeordnet, wobei jedem Kleinspannungsanschluss 22 eine eigene Sicherheitsleitung 36 zugeordnet ist.

Die Sicherheitsschaltung 35 ist eingerichtet, einen der Kleinspannungsanschlüsse 22 abzuschalten. Dies kann beispielsweise aufgrund einer Datenübertragung mittels Datenleitung 31 zur Sicherheitsschaltung 35 ausgelöst werden. Ein Signal zur Abschaltung des Kleinspannungsanschlusses 22 kann dabei über die Sicherheitsleitung 36 weitergegeben werden. Beispielsweise kann dies über das Anlegen einer Schaltspannung an die Sicherheitsleitung 36 erfolgen, mit der ein Relais, ein Transistor oder ein anderer Schalter am Kleinspannungsanschluss 22 geschaltet werden kann. Alternativ kann mittels der Sicherheitsleitung 36 auch ein Schaltsignal an ein Funktionsmodul weitergegeben werden und ein Relais, ein Transistor oder ein anderer Schalter in einem Funktionsmodul angeordnet sein.

Die erste Trennwand 54 kann auch weggelassen werden. Ferner können die Datenanschlüsse 21, Kleinspannungsanschlüsse 22, Niederspannungsanschlüsse 23, die Datenleitung 31, die Kleinspannungsleitung 32, die Niederspannungsleitung 33, die Sicherheitsleitungen 36 sowie die Sicherheitsschaltung 35 auf einer gemeinsamen Leiterkarte untergebracht werden.

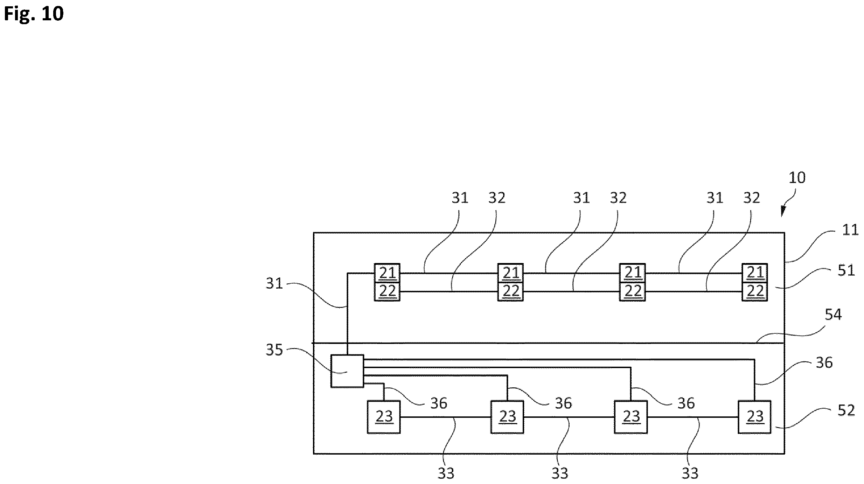

Fig. 10 zeigt eine Draufsicht auf ein geöffnetes Gehäuse 11 eines weiteren Basismoduls 10. Das Basismodul 10 ist identisch zum Basismodul 10 der Fig. 9 aufgebaut, sofern im Folgenden keine Unterschiede beschrieben sind. Die Datenanschlüsse 21, Kleinspannungsanschlüsse 22, Niederspannungsanschlüsse 23, die Datenleitung 31, die Kleinspannungsleitung 32, die Niederspannungsleitung 33, die Sicherheitsleitungen 36 sowie die Sicherheitsschaltung 35 sind nicht auf einer Leiterkarte untergebracht. In diesem Fall kann vorgesehen sein, dass die Anschlusselemente, also die Datenanschlüsse 21, die Kleinspannungsanschlüsse 22, die Niederspannungsanschlüsse 23 und die Sicherheitsschaltung 35 direkt mit dem Gehäuse 11 verbunden sind. Die Datenleitung 31, die Kleinspannungsleitung 32, die Niederspannungsleitung 33 und die Sicherheitsleitungen 36 können dann frei im Gehäuse 11 verlegt sein. Alternativ wäre es jedoch möglich, Datenanschlüsse 21, Kleinspannungsanschlüsse 22, Niederspannungsanschlüsse 23, die Datenleitung 31, die Kleinspannungsleitung 32, die Niederspannungsleitung 33, Sicherheitsleitungen 36 sowie die Sicherheitsschaltung 35 auf einer Leiterkarte oder mehreren Leiterkarten analog zu Fig. 9 unterzubringen. Die Sicherheitsleitungen 36 sind zwischen der Sicherheitsschaltung 35 und den Niederspannungsanschlüssen 23 angeordnet, wobei jedem Niederspannungsanschluss 23 eine eigene Sicherheitsleitung 36 zugeordnet ist.

Die Sicherheitsschaltung 35 ist eingerichtet, zumindest einen der Niederspannungsanschlüsse 23 abzuschalten. Dies kann beispielsweise aufgrund einer Datenübertragung mittels Datenleitung 31 zur Sicherheitsschaltung 35 ausgelöst werden.

Ein Signal zur Abschaltung des Niederspannungsanschlusses 23 kann dabei über die Sicherheitsleitung 36 weitergegeben werden. Beispielsweise kann dies über das Anlegen einer Schaltspannung an die Sicherheitsleitung 36 erfolgen, mit der ein Relais, ein Transistor oder ein anderer Schalter am Niederspannungsanschluss 23 geschaltet werden kann.

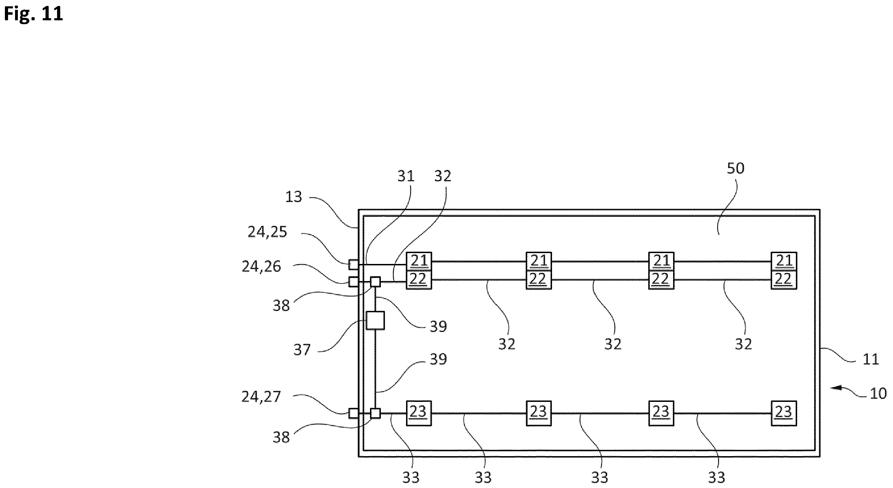

Fig. 11 zeigt eine Draufsicht auf ein geöffnetes Gehäuse 11 eines weiteren Basismoduls 10, welches dem Basismodul 10 der Fig. 3 entspricht, sofern im Folgenden keine Unterschiede beschrieben sind. Das Basismodul weist eine Leiterkarte 50 auf, auf der Datenanschlüsse 21, Kleinspannungsanschlüsse 22, Niederspannungsanschlüsse 23, die Datenleitung 31, die Kleinspannungsleitung 32 und die Niederspannungsleitung 33 angeordnet sind. Ferner weist das Basismodul 10 Gehäuseanschlüsse 24 auf, wobei die Gehäuseanschlüsse 24 einen Gehäusedatenanschluss 25, einen Gehäusekleinspannungsanschluss 26 sowie einen Gehäuseniederspannungsanschluss 27 umfassen. Der Gehäusedatenanschluss 25 ist mittels einer Datenleitung 31 mit den Datenanschlüssen 21 verbunden. Der Gehäusekleinspannungsanschluss 26 ist mit einer Kleinspannungsleitung 32 mit den Kleinspannungsanschlüssen 22 verbunden. Der Gehäuseniederspannungsanschluss 27 ist mit einer Niederspannungsleitung 33 mit den Niederspannungsanschlüssen 23 verbunden.

Die Gehäuseanschlüsse 24 sind an einer weiteren Gehäuseseite 13 angeordnet. Mittels der Gehäuseanschlüsse 24 kann ein Feldbus über den Gehäusedatenanschluss 25, eine Kleinspannung über den Gehäusekleinspannungsanschluss 26 sowie eine Niederspannung über den Gehäuseniederspannungsanschluss 27 bereitgestellt werden. Feldbus, Kleinspannung und Niederspannung stehen dabei ihrerseits über die Datenanschlüsse 21, die Kleinspannungsanschlüsse 22 sowie die Niederspannungsanschlüsse 23 für Funktionsmodule bereit.

Es kann vorgesehen sein, die Gehäuseanschlüsse 24 auch auf der ersten Gehäuseseite 12 anzuordnen.

Zusätzlich weist das Basismodul 10 der Fig. 11 eine Überwachungsschaltung 37 auf. Die Überwachungsschaltung 37 ist eingerichtet, einen Umgebungsparameter zu ermitteln. Dies kann durch einen eigenen Sensor, der der Überwachungsschaltung 37 zugeordnet ist, geschehen. Alternativ kann die Überwachungsschaltung 37 an die Datenleitung 31 angeschlossen sein und ein Sensorsignal über die Datenleitung 31 empfangen. Die Überwachungsschaltung 37 ist mittels zweier Überwachungsleitungen 39 mit zwei Schaltern 38 verbunden, wobei ein Schalter 38 in der Kleinspannungsleitung 32 und ein Schalter 38 in der Niederspannungsleitung 33 abgeordnet ist. Über die Schalter 38 kann die Überwachungsschaltung 37 das Basismodul 10 abschalten und so in einen sicheren Betriebszustand überführen. Dies kann beispielsweise dadurch ausgelöst werden, dass der Umgebungsparameter außerhalb eines vorbestimmten Wertebereichs liegt. Der Umgebungsparameter kann insbesondere eine Neigung oder eine Schwingung umfassen. Dadurch kann beispielsweise eine automatische Abschaltung des Basismoduls 10 bei einer unkorrekten Einbaulage des Basismoduls 10 ausgelöst werden.

Die Überwachungsschaltung 37 kann dabei als steckbare Leiterkarte ausgeführt sein, welche in einen dafür vorgesehenen Einsatz innerhalb des Basismoduls 10 eingesteckt werden kann.

Obwohl im Basismodul der Fig. 11 sowohl die Gehäuseanschlüssen 24 als auch die Überwachungsschaltung 37 mit Schaltern 38 und Überwachungsleitungen 39 dargestellt sind, sind diese Merkmale unabhängig voneinander und können jeweils einzeln in den Basismodulen 10 der vorherigen Ausführungsbeispiele realisiert werden.

Alternativ zu den Gehäuseanschlüssen 24 kann auch vorgesehen sein, dass Daten und/oder eine Kleinspannung und/oder eine Niederspannung über ein Funktionsmodul in das Basismodul 10 eingebracht werden. Der Anschluss erfolgt damit über die Anschlusselemente 20. Eine Abschaltung aufgrund der Überwachungsschaltung 37 und/oder der in Fig. 9 gezeigten Sicherheitsschaltung 35 erfolgt dann zwischen dem zur Einspeisung vorgesehenen Anschlusselement und den Anschlusselementen der weiteren Steckplätze.

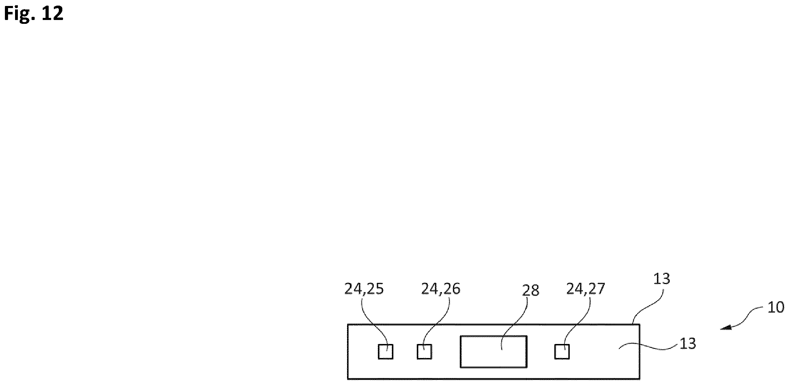

Fig. 12 zeigt eine Seitenansicht auf der weiteren Gehäuseseite 13 des Basismoduls der Fig. 11, an der die Gehäuseanschlüsse 24 angeordnet sind. Zusätzlich zu den Gehäuseanschlüssen 24 ist eine optionale Druckausgleichmembran 28 an der weiteren Gehäuseseite angeordnet, mit der ein Innendruck innerhalb des Gehäuses 11 an einen Außendruck außerhalb des Gehäuses 11 angeglichen werden kann. Die Druckausgleichsmembran 28 ist ebenfalls bei den Basismodulen 10 der vorherigen Ausführungsbeispiele verwendbar. Ferner kann die Druckausgleichsmembran 28 unabhängig von den Gehäuseanschlüssen 24 realisiert werden.

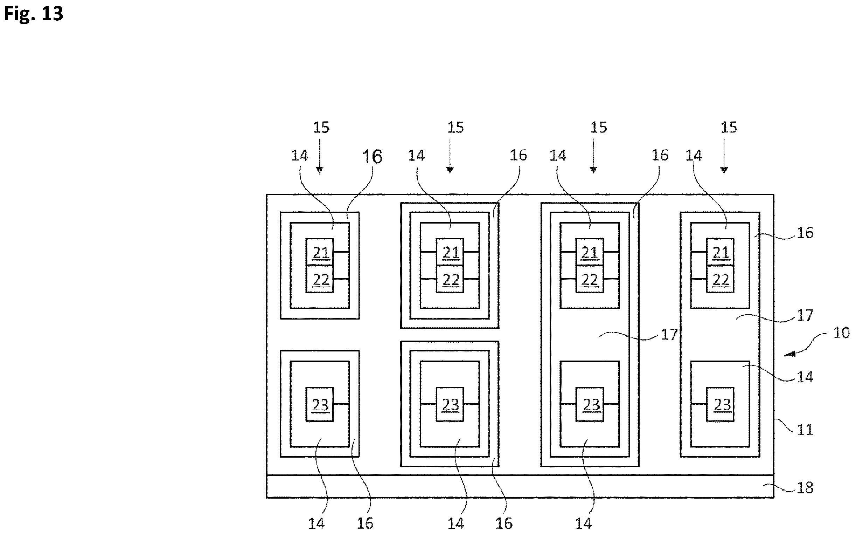

Fig. 13 zeigt eine Draufsicht auf ein weiteres Basismodul 10, welches dem Basismodul 10 der Fig. 3 und 4 entspricht, sofern im Folgenden keine Unterschiede beschrieben sind. An jedem Steckplatz 15 ist mindestens eine Dichtung 16 vorgesehen, wobei die Dichtungen 16 jeweils mindestens um eine Öffnung 14 umläuft. Insgesamt sind vier verschiedene mögliche Ausgestaltungen der Dichtung 16 in Fig. 13 dargestellt.

Eine erste Möglichkeit für die Ausgestaltung der Dichtung 16 ist, dass zwei Dichtungen 16 um beide Öffnungen 14 eines Steckplatzes 15 umlaufend angeordnet sind. Jede der Öffnungen 14 eines Steckplatzes weist also eine eigene Dichtung 16 auf. Die Dichtungen 16 grenzen dabei direkt an die Öffnungen 14 an. Diese Ausgestaltung ist am linken der vier Steckplätze 15 gezeigt.

In einer zweiten Möglichkeit für die Ausgestaltung der Dichtung 16 sind ebenfalls zwei Dichtungen 16 um beide Öffnungen 14 eines Steckplatzes 15 umlaufend angeordnet. Die Dichtungen 16 sind dabei beabstandet zu den Öffnungen 14 angeordnet. Diese Ausgestaltung ist am zweiten Steckplatz 15 von links gezeigt.

Eine dritte Möglichkeit für die Ausgestaltung der Dichtung 16 ist, dass die Dichtung 16 um beide Öffnungen 14 eines Steckplatzes 15 umlaufend angeordnet ist. Die Dichtung 16 ist auch bezüglich eines Zwischenraums 17 zwischen den Öffnungen 14 umlaufend. Diese Ausgestaltung ist am zweiten Steckplatz 15 von rechts gezeigt. Die Dichtung 16 kann dabei wiederum direkt an die Öffnungen 14 angrenzen oder beabstandet (wie hier dargestellt) angeordnet sein.

Eine vierte Möglichkeit für die Ausgestaltung der Dichtung 16 ist eine um beide Öffnungen 14 eines Steckplatzes 15 umlaufende Dichtung 16, die ebenfalls einen Zwischenraum 17 zwischen den Öffnungen 14 bedeckt. Die Dichtung 16 ist also als Flächendichtung ausgestaltet. Diese Ausgestaltung ist am rechten der vier Steckplätze 15 gezeigt. Die Dichtung 16 kann dabei wiederum direkt an die Öffnungen 14 angrenzen (wie hier dargestellt) oder beabstandet angeordnet sein.

Beim Anbringen eines Funktionsmoduls am Basismodul 10 kann es vorgesehen sein, dass die Dichtung in einem gewissen Maß zusammengedrückt wird, um eine Abdichtung gegen Staub und Flüssigkeiten realisieren zu können. Es kann vorgesehen sein, dass sich aufgrund dieses Zusammendrückens eine Dicke der Dichtung nach dem Anbringen eines Funktionsmoduls um bis zu fünfundzwanzig Prozent verringert.

Zusätzlich weist das Basismodul 10 eine Erdungsschiene 18 auf. Die Erdungsschiene 18 kann zur Erdung von Anlagenteilen dienen, wenn das Basismodul 10 in einem Schaltschranksystem eingesetzt wird.

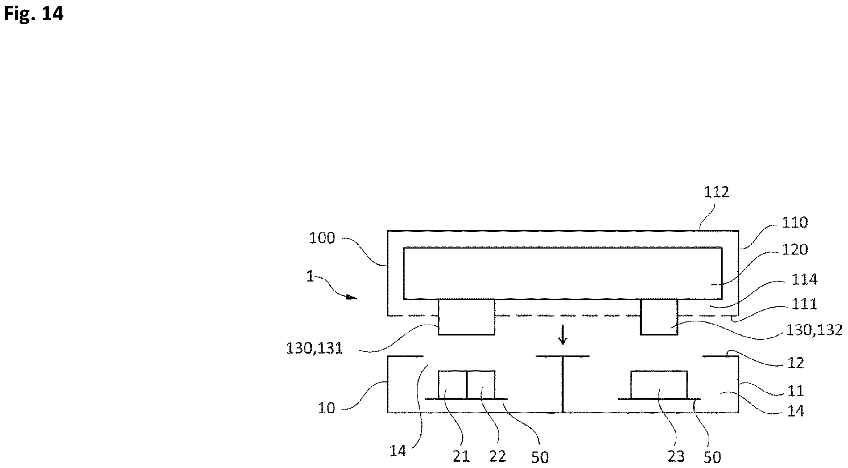

Fig. 14 zeigt einen Querschnitt durch ein Schaltschranksystem 1 aus einem Basismodul 10 und einem Funktionsmodul 100. Das Basismodul 10 entspricht dabei dem in Fig. 3 und 4 gezeigten Basismodul 10 mit zwei Kanälen 51, 52. Das Funktionsmodul 100 weist ein Modulgehäuse 110 sowie eine elektronische Schaltung 120 innerhalb des Modulgehäuses 110 auf, wobei die elektronische Schaltung 120 auf einer Leiterkarte angeordnet sein kann. Eine Modulgehäuseseite 111 des Modulgehäuses 110 mit der Modulgehäuseöffnung 114 ist dem Basismodul 10 zugewandt. Ferner weist das Modulgehäuse 110 weitere Modulgehäuseseiten 112 auf. Die erste Gehäuseseite 12 mit den Öffnungen 14 des Basismoduls 10 ist dem Funktionsmodul 100 zugewandt. Ferner weist das Funktionsmodul 100 zwei Anschlusselemente 130 auf, die als erstes Steckelement 131 und als zweites Steckelement 132 ausgestaltet sind. Das erste Steckelement 131 ist dabei eingerichtet, in den Datenanschluss 21 sowie den Kleinspannungsanschluss 22 des Basismoduls 10 einzugreifen. Das zweite Steckelement 132 ist eingerichtet, in den Niederspannungsanschluss 23 des Basismoduls 10 einzugreifen. Alternativ kann das zweite Steckelement 132 weggelassen werden. Dann greift nur das erste Steckelement 131 in den Datenanschluss 21 sowie den Kleinspannungsanschluss 22 des Basismoduls 10 ein, wodurch das Funktionsmodul 100 nicht auf die Niederspannung zurückgreifen kann. Ferner kann vorgesehen sein, dass das erste Steckelement 131 ausschließlich in den Datenanschluss 21 eingreift. Dann stehen dem Funktionsmodul 100 nur die Daten und je nachdem, ob das zweite Steckelement 132 vorhanden ist, die Niederspannung zur Verfügung. In Fig. 14 sind Basismodul 10 und Funktionsmodul 100 noch nicht miteinander verbunden, sondern beabstandet zueinander angeordnet. Mit einem Pfeil ist eine Bewegung des Funktionsmoduls 100 hin zum Basismodul 10 angedeutet, wodurch das Funktionsmodul 100 in das Basismodul 10 eingesteckt wird. Wie in Fig. 14 dargestellt, kann die erste Gehäuseseite 12 und die erste Modulgehäuseseite 111 eben ausgestaltet sein.

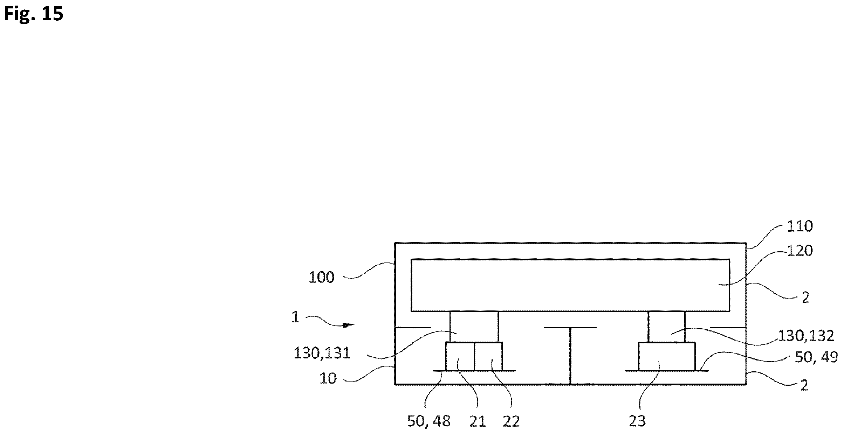

Fig. 15 zeigt einen Querschnitt des Schaltschranksystems 1 der Fig. 14 nach dem Einstecken des Funktionsmoduls 100 in das Basismodul 10. Nach dem Anbringen des Funktionsmoduls 100 am Basismodul 10 sind die Öffnungen 14 beziehungsweise die Modulgehäuseöffnung 114 nicht mehr zugänglich, da Gehäuse 11 und Modulgehäuse 110 ein gemeinsames Gehäuse 2 bilden.

Alternativ zu dem in den Fig. 14 und 15 gezeigten Schaltschranksystem 1 kann auch eines der anderen Ausführungsbeispiele des Basismoduls 10 verwendet werden. Insbesondere kann ein Ausführungsbeispiel ohne Kanäle 51, 52, oder mit dem dritten Kanal 53, oder mit einer gemeinsamen Öffnung 14 für alle Anschlusselemente 20 verwendet werden.

Das Modulgehäuse 110 entspricht in seinen Abmessungen quer zu den Kanälen 51, 52 dem Basismodul 10. Das Modulgehäuse 110 kann kleiner oder größer ausgestaltet sein und beispielsweise das Basismodul 10 überragen. Ferner kann das Modulgehäuse 110, wenn nicht in den Niederspannungsanschluss 23 eingegriffen wird, auch derart ausgestaltet sein, dass die Öffnung 14 oberhalb des Niederspannungsanschlusses 23 nicht durch das Modulgehäuse 110 abgedeckt wird. In diesem Fall kann ein zusätzlicher Deckel oder alternativ ein Funktionsmodul 100, welches ausschließlich ein Modulgehäuse 110 aufweist und auch als Leermodul bezeichnet werden kann, zur Abdeckung dieser Öffnung 14 vorgesehen werden.

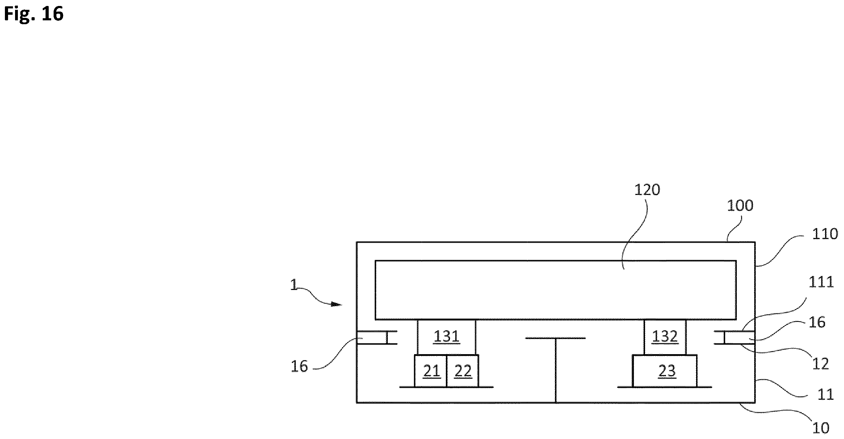

Fig. 16 zeigt einen Querschnitt durch ein weiteres Schaltschranksystem 1, welches dem Schaltschranksystem 1 der Fig. 15 entspricht, sofern im Folgenden keine Unterschiede beschrieben sind. Eine Dichtung 16 ist zwischen dem Basismodul 10 und dem Funktionsmodul 100 angeordnet. Die Dichtung 16 kann dabei einer der in Fig. 13 gezeigten Varianten entsprechen und am Basismodul 10 angeordnet sein. Alternativ kann die Dichtung 10 auch erst vor dem Einstecken des Funktionsmoduls 100 eingelegt werden. Als dritte Alternative kann die Dichtung 16 dem Funktionsmodul 100 zugeordnet sein. Durch die Dichtung kann erreicht werden, dass das gemeinsame Gehäuse 2 staubdicht und dicht gegen das Eindringen von Flüssigkeiten ist und dadurch beispielsweise die Schutzklasse IP67 erreicht wird.

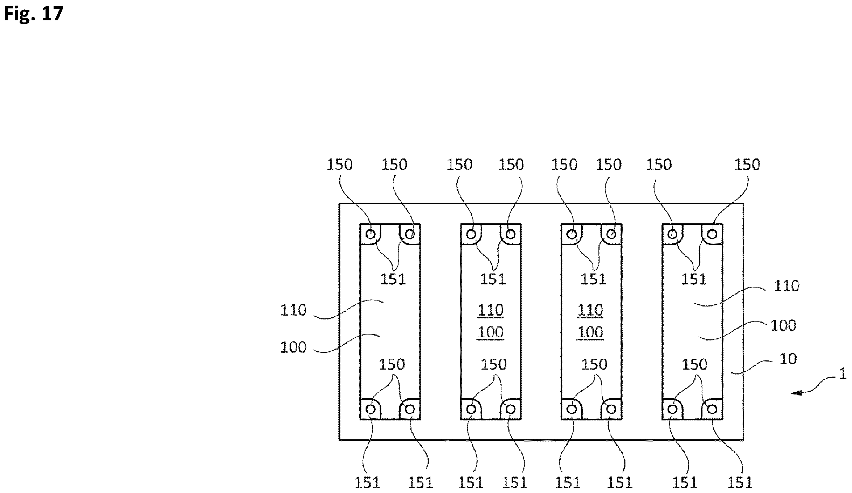

Fig. 17 zeigt eine Draufsicht auf ein Schaltschranksystem 1 bestehend aus einem Basismodul 10 und vier Funktionsmodulen 100 mit jeweils einem Modulgehäuse 110. Die Modulgehäuse 110 weisen jeweils vier Ausnehmungen 151 mit vier Durchgangslöchern 150 auf. Jeweils eine (in Fig. 17 nicht gezeigte) Schraube kann zum Anschrauben der Funktionsmodule 100 an das Basismodul 10 durch jeweils eine Durchgangsöffnung 150 geführt werden. Im Basismodul 10 kann die Schraube jeweils in ein Gewindeloch 44 eingreifen. Die Gewindelöcher 44 können dabei analog zu den in Fig. 3 gezeigten Gewindelöchern 44 ausgestaltet sein. Ein Schraubenkopf kann dabei innerhalb der Ausnehmung 151 angeordnet sein.

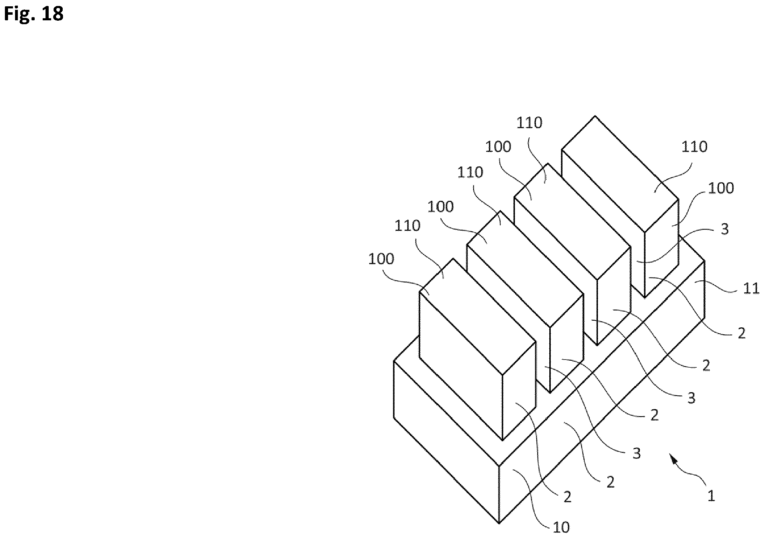

Fig. 18 zeigt eine stark vereinfachte isometrische Ansicht eines Schaltschranksystems 1 aus einem Basismodul 10 und vier Funktionsmodulen 100. Zwischen den Funktionsmodulen 100 ist ein Modulzwischenraum 3 frei, der zu einer Belüftung der Funktionsmodule 100 genutzt werden kann. Das Gehäuse 10 und die Modulgehäuse 110 bilden ein gemeinsames Gehäuse 2, welches staub- und Flüssigkeitsdicht ist.

Es können auch mehr oder weniger als vier Funktionsmodule 100 auf dem Basismodul 10 angeordnet sein. Insbesondere können die Funktionsmodule 100 auch eine größere Breite aufweisen. Dies bedeutet, dass ein Funktionsmodul 100 mehrere Spalten von Anschlusselementen 20 und die zugehörigen Öffnungen 14 abdecken kann.

Die Funktionsmodule 100 können dabei insbesondere Eingangsmodule, Ausgangsmodule, Rechnermodule, Netzwerkswitchmodule, Servosteuerungsmodule, Netzfiltermodule, SPS-Steuerungsmodule, Motorsteuerungsmodule, Schützmodule, Buskopplermodule, Frequenzumrichtermodule und/oder Netzteilmodule oder eine Kombination der genannten Module umfassen. Die Funktionsmodule 100 können dabei die Funktionalitäten bereitstellen, die in bekannten Schaltschränken zur Verfügung stehen.

Das Gehäuse 11 des Basismoduls 10 beziehungsweise das Modulgehäuse 110 des Funktionsmoduls 100 kann dabei als Stangenpressprofil ausgeführt werden. Alternativ kann das Gehäuse 11 beziehungsweise das Modulgehäuse 110 als Druckguss ausgeführt sein. Als Materialien kommen insbesondere Aluminium oder Zink oder eine Legierung der genannten Metalle in Frage.

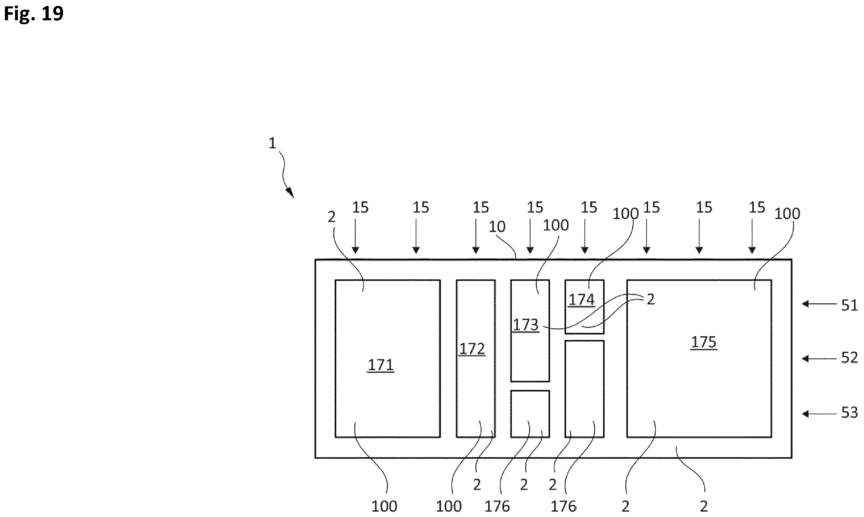

Fig. 19 zeigt eine Draufsicht auf ein weiteres Schaltschranksystem 1 aus einem Basismodul 10 und fünf Funktionsmodulen 100, die wie bereits beschrieben am Basismodul angebracht sind. Das Basismodul weist dabei wie in Fig. 5 und 6 gezeigt, drei Kanäle 51, 52, 53 auf, wobei insgesamt acht Steckplätze 15 am Basismodul 10 angeordnet sind. Ein erstes Funktionsmodul 171 erstreckt sich über alle drei Kanäle 51, 52, 53 und zwei Steckplätze 15. Ein zweites Funktionsmodul 172 erstreckt sich über alle drei Kanäle 51, 52, 53 und einen Steckplatz 15. Ein drittes Funktionsmodul 173 erstreckt sich über den ersten Kanal 51 und den zweiten Kanal 52 und einen Steckplatz 15. Ein Deckel 176 verschließt den dritten Kanal 53 an diesem Steckplatz 15. Anstelle eines oder mehrerer Deckel 176 können auch Leergehäuse oder andere Funktionsmodule vorgesehen sein. Ein viertes Funktionsmodul 174 erstreckt sich über den ersten Kanal 51 und einen Steckplatz 15. Der zweite Kanal 52 und der dritte Kanal 53 sind an diesem Steckplatz 15 ebenfalls mit einem Deckel 176 verschlossen. Ein fünftes Funktionsmodul 175 erstreckt sich über alle drei Kanäle 51, 52, 53 und drei Steckplätze 15.

Das erste Funktionsmodul 171, das zweite Funktionsmodul 172 und das fünfte Funktionsmodul 175 können Modulanschlusselemente aufweisen, die in Datenanschlüsse, Kleinspannungsanschlüsse und Niederspannungsanschlüsse des Basismoduls 10 eingreifen. Ferner kann dem ersten Funktionsmodul 171, dem zweiten Funktionsmodul 172 und dem fünften Funktionsmodul 175 Kühlluft aus dem dritten Kanal 53 zur Verfügung stehen. Das dritte Funktionsmodul 173 kann ebenfalls Modulanschlusselemente aufweisen, die in Datenanschlüsse, Kleinspannungsanschlüsse und Niederspannungsanschlüsse des Basismoduls 10 eingreifen, die Kühlluft aus dem dritten Kanal 53 steht dem dritten Funktionsmodul 173 jedoch nicht zur Verfügung. Das vierte Funktionsmodul 174 kann Modulanschlusselemente aufweisen, die in Datenanschlüsse und Kleinspannungsanschlüsse des Basismoduls 10 eingreifen, die aus dem dritten Kanal 53 Kühlluft sowie die Niederspannung steht dem vierten Funktionsmodul 174 jedoch nicht zur Verfügung.

Die Deckel 176 sind Teil des gemeinsamen Gehäuses 2 des Schaltschranksystems 1 und dienen dazu, die Öffnungen des Basismoduls 10 gegen Eindringen von Gegenständen, Staub und Flüssigkeiten zu schützen, die nicht durch die Funktionsmodule 171, 172, 173, 174, 175 abgedeckt sind.

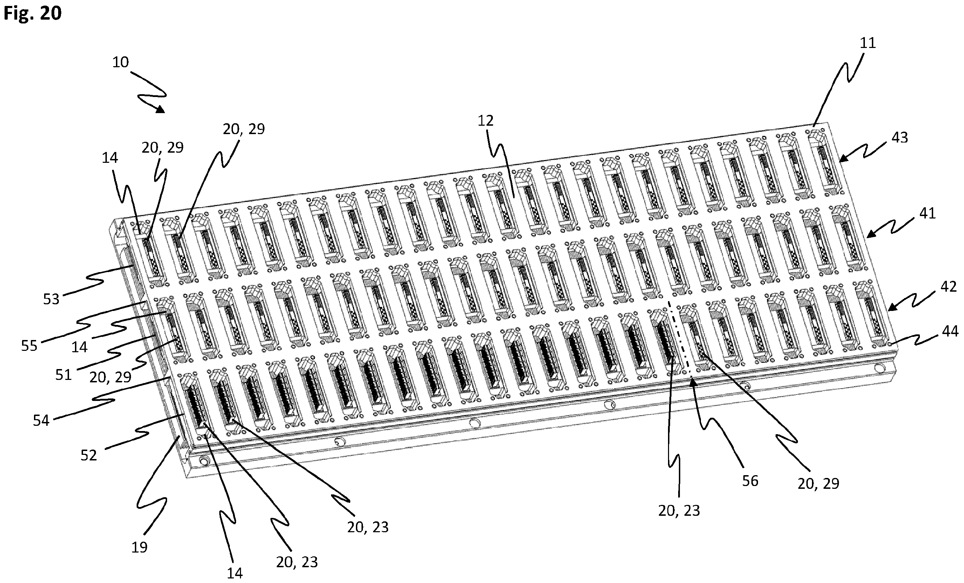

Fig. 20 zeigt eine isometrische Ansicht eines Basismoduls 10, welches dem Basismodul 10 der Fig. 5 und 6 entspricht, sofern im Folgenden keine Unterschiede beschrieben sind. Im Gegensatz zum Basismodul der Fig. 5 und 6 sind in Fig. 20 die ersten bis dritten Reihen 41, 42, 43 der Öffnungen 14 in einer anderen Reihenfolge angeordnet. Die erste Reihe 41 von Öffnungen 14 ist mittig angeordnet, die zweite Reihe 42 und die dritte Reihe 43 von Öffnungen 14 sind auf gegenüberliegenden Seiten der ersten Reihe 41 angeordnet. Der erste Kanal 51, welcher der ersten Reihe 41 zugeordnet ist, ist also ebenfalls mittig, zwischen dem zweiten Kanal 52 und dem dritten Kanal 53 angeordnet. Folglich grenzen sowohl die erste Trennwand 54 als auch die zweite Trennwand 55 an den ersten Kanal 51 an.

In allen ersten bis dritten Kanälen 51, 52, 53 sind Anschlusselemente 20 angeordnet. Im ersten Kanal 51 sind dabei kombinierte Anschlüsse 29 für Daten und Kleinspannungen vorgesehen. Anders ausgedrückt stellt der kombinierte Anschluss 29 ein Anschlusselement 20 dar, welches die Funktionen des Datenanschlusses 21 und des Kleinspannungsanschlusses 22 der Fig. 5 und 6 kombiniert.

Im zweiten Kanal 52 sind Niederspannungsanschlüsse 23 angeordnet. Dabei ist jedoch im Gegensatz zu den Fig. 5 und 6 nicht vorgesehen, dass allen Öffnungen 14 der zweiten Reihe 42 jeweils ein Niederspannungsanschluss 23 zugeordnet ist. Die Niederspannungsanschlüsse 23 sind im zweiten Kanal 52 nur bis zu einer Grenze 56 angeordnet. Die Grenze ist in Fig. 20 und in den folgenden Figuren mittels einer Strich-Punkt-Linie verdeutlicht. Im Bereich der verbleibenden Öffnungen 14 der zweiten Reihe 42 sind im zweiten Kanal 52 analog zum ersten Kanal 51 kombinierte Anschlüsse 29 angeordnet. Mit einer solchen Anordnung können unterschiedliche Anforderungen an ein Schaltschranksystem aus Basismodul 10 und Funktionsmodulen 100 erfüllt werden und dabei gleichzeitig eine bessere Ausnutzung der durch das Basismodul 10 bereitgestellten Steckplätze für Funktionsmodule realisiert werden.

Im dritten Kanal 53 sind ebenfalls gemeinsame Anschlüsse 29 angeordnet, analog zum ersten Kanal 51 und einem Teil des zweiten Kanals 52. Zusätzlich kann vorgesehen sein, dass Kühlluft durch den dritten Kanal 53 geführt wird. Alternativ oder zusätzlich können auch der erste Kanal 51 und/oder der zweite Kanal 52 zum Führen von Kühlluft genutzt werden.

Unterhalb der ersten bis dritten Kanäle 51, 52, 53 sind Kühlelemente 19 angeordnet. Diese sind als Kühlrippen ausgestaltet, können jedoch auch eine andere Form aufweisen. Die Kühlelemente 19 können zum Wärmetransport vom Inneren des Gehäuses 11 in die Umgebung eingerichtet sein. Um die Öffnungen 14 sind Sacklöcher 44 mit Innengewinde angeordnet, die der Befestigung von Funktionsmodulen am Basismodul 10 dienen können. Wie in Fig. 20 dargestellt, kann die erste Gehäuseseite 12 eben ausgestaltet sein.

In Fig. 20 nicht gezeigte Datenleitungen können alle kombinierten Anschlüsse 29 miteinander derart verbinden, dass ein Feldbus über alle kombinierten Anschlüsse 29 abgegriffen werden kann.

Die kombinierten Anschlüsse 29 können unterhalb der Öffnungen 14 angeordnet sein. Die Niederspannungsanschlüsse 23 können ebenfalls unterhalb der Öffnungen 14 angeordnet sein. Alternativ können die Niederspannungsanschlüsse durch die Öffnungen 14 geführt und damit auch teilweise oberhalb der ersten Seite 12 angeordnet sein.

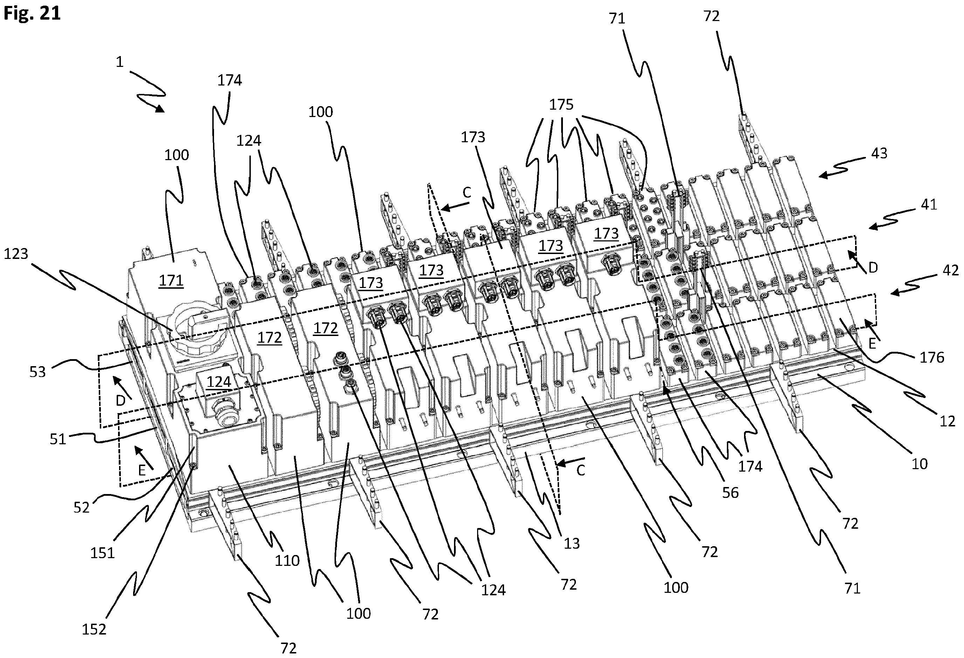

Fig. 21 zeigt ein Schaltschranksystem 1 bestehend aus dem Basismodul 10 der Fig. 20 sowie mehreren Funktionsmodulen 100. Die Funktionsmodule 100 sind dabei analog zu Fig. 19 unterschiedlich groß und decken eine unterschiedliche Anzahl von Öffnungen ab. Ferner sind ebenfalls analog zu Fig. 19 Deckel 176 oberhalb von Öffnungen ohne Funktionsmodulen 100 angeordnet. Die Funktionsmodule 100 können wie in den Fig. 14 bis 18 gezeigt mit dem Basismodul 10 verbunden werden.

Bis zur Grenze 56 in den Bereichen, in denen im zweiten Kanal 52 Niederspannungsanschlüsse angeordnet sind, überdecken die Funktionsmodule sowohl den ersten Kanal 51 als auch den zweiten Kanal 52. Ein erstes Funktionsmodul 171 in diesem Bereich überdeckt zusätzlich auch den dritten Kanal 53, während zweite Funktionsmodule 172 und dritte Funktionsmodule 173 nur den ersten Kanal 51 und den zweiten Kanal 52 überdecken. Vierte Funktionsmodule 174 und fünfte Funktionsmodule 175 überdecken jeweils nur einen der ersten bis dritten Kanäle 51, 52, 53. Der dritte Kanal 53 ist dabei außer vom ersten Funktionsmodul 171 nur von vierten Funktionsmodulen 174 und fünften Funktionsmodulen 175 überdeckt. Der erste Kanal 51 und der der zweite Kanal 52 sind ab der Grenze 56 von den vierten Funktionsmodulen 174 überdeckt, also in Bereichen, in denen im zweiten Kanal 52 kombinierte Anschlüsse angeordnet sind. Dadurch steht für jedes Funktionsmodul 100 mindestens ein kombinierter Anschluss 29 zur Verfügung, wodurch alle Funktionsmodule 100 an den Feldbus angeschlossen werden können.

Das erste Funktionsmodul 171 weist dabei sowohl ein Regelelement 123 als auch ein Peripherieanschlusselement 124 auf. Die weiteren zweiten bis fünften Funktionsmodule 172, 173, 174, 175 weisen keine Regelelemente 123 und nur teilweise Peripherianschlusselemente 124 auf. Mittels Schrauben 152, die in Ausnehmungen 151 der Modulgehäuse 110 angeordnet sind, werden die Funktionsmodule 100 an dem Basismodul 10 befestigt. Die Schrauben 152 greifen dabei in die in Fig. 20 gezeigten Gewindelöcher 44 ein, analog zu der Beschreibung im Zusammenhang mit den Fig. 3 und 17.

Auf der ersten Gehäuseseite 12 des Basismoduls 10 sind erste Kabelführungselemente 71 angeordnet, die dem geordneten Führen von an die Peripherieanschlusselemente 124 angeschlossenen, nicht dargestellten Kabeln dienen. Auf weiteren Gehäuseseiten 13 sind zweite Kabelführungselemente 72 angeordnet, die ebenfalls dem geordneten Führen von an die Peripherieanschlusselemente 124 angeschlossenen, nicht dargestellten Kabeln dienen.

Da alle Öffnungen des Basismoduls 10 mittels der Funktionsmodule 100 beziehungsweise der Deckel 176 verschlossen sind, ist das Schaltschranksystem 1 flüssigkeitsdicht und staubdicht ausgestaltet.

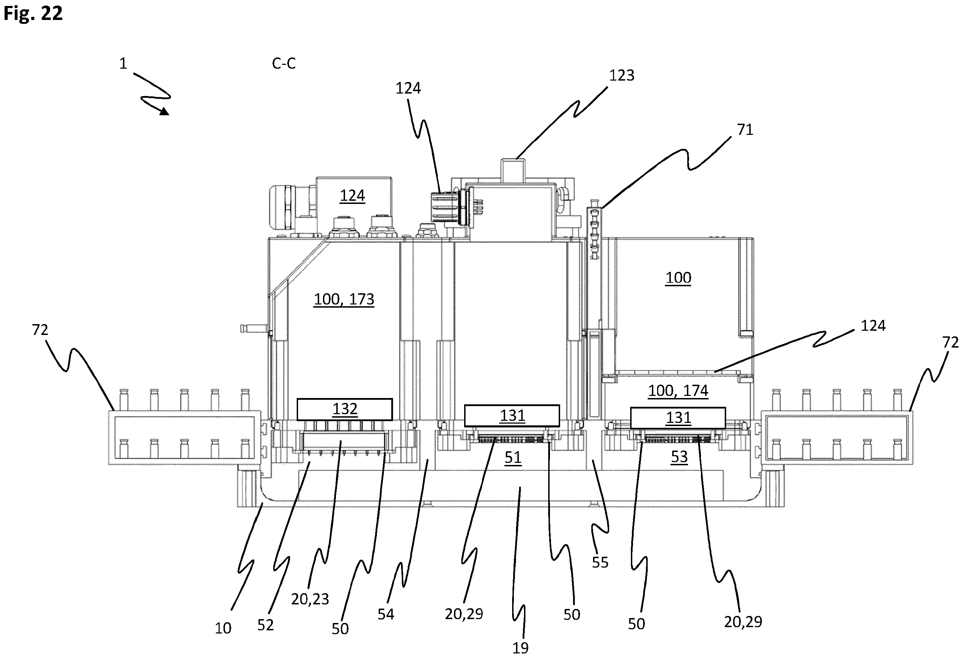

Fig. 22 zeigt einen Querschnitt durch das Schaltschranksystem 1 der Fig. 21 im Bereich eines der dritten Funktionsmodule 173 an der mit C bezeichneten Schnittebene. Die Kühlelemente 19 sind über alle drei ersten bis dritten Kanäle 51, 52, 53 geführt, wobei die Trennwände 54, 55 bis an die Kühlelemente 19 reichen. Das geschnittene dritte Funktionsmodul 173 weist ein erstes Steckelement 131 auf, welches in den kombinierten Anschluss 29 des ersten Kanals 51 eingreift. Ein zweites Steckelement 132 des dritten Funktionsmoduls 173 greift in den Niederspannungsanschluss 23 ein. Ein erstes Steckelement 131 des vierten Funktionsmoduls 174 greift in den kombinierten Anschluss 29 des dritten Kanals 53 ein.

Querschnitte der weiteren in Fig. 21 gezeigten Funktionsmodule 100 sind nicht dargestellt, die weiteren Funktionsmodule 100 können aber analog zu den in Fig. 22 gezeigten Funktionsmodulen 173, 174 mit den Anschlusselementen 20 mittels Steckelementen 131, 132 verbunden werden.

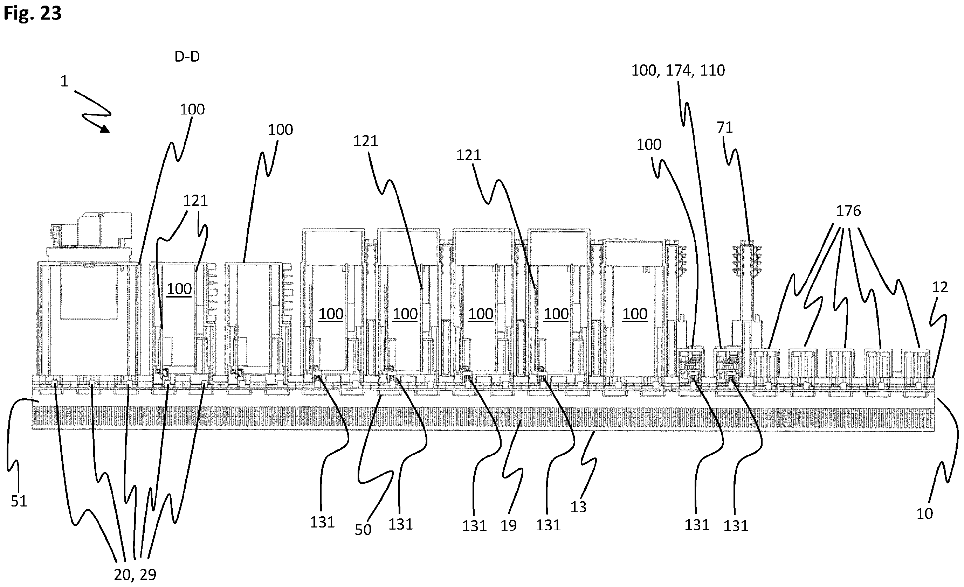

Fig. 23 zeigt einen Querschnitt durch das Schaltschranksystem 1 der Fig. 21 entlang des ersten Kanals 51 an der mit D bezeichneten Schnittebene. Erste Steckelemente 131 greifen in die kombinierten Anschlüsse 29 ein. Die Deckel 176 entsprechen im Wesentlichen den Modulgehäusen 110 der vierten Funktionsmodule 174, jedoch ohne elektronische Schaltung und Peripherieanschlusselemente. Die Kühlelemente 19 sind vollständig über eine weitere Gehäuseseite 13, die der ersten Gehäuseseite 12 gegenüberliegt geführt. Es kann alternativ vorgesehen sein, die Kühlelemente 19 nur in einem Teilbereich des Basismoduls 10 vorzusehen.

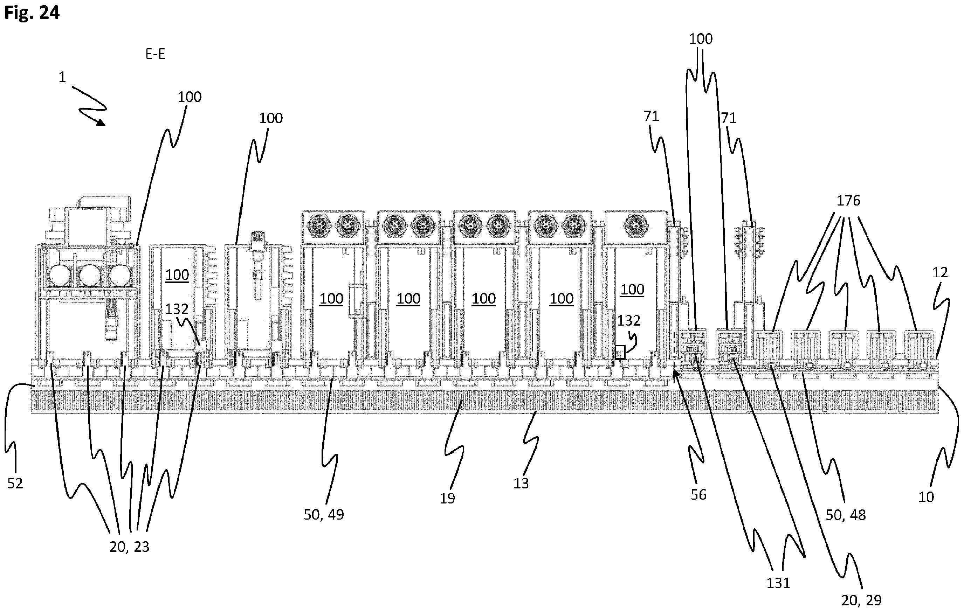

Fig. 24 zeigt einen Querschnitt durch das Schaltschranksystem 1 der Fig. 21 entlang des zweiten Kanals 52 an der mit E bezeichneten Schnittebene. Auf einer Seite der Grenze 56, in der Darstellung der Fig. 24 links, greifen zweite Steckelemente 132 in die Niederspannungsanschlüsse 23 ein, nicht jedoch für jedes der Funktionsmodule 100 in diesem Bereich. Insbesondere greifen diejenigen der Funktionsmodule, die keine Niederspannung benötigen, nicht in die Niederspannungsanschlüsse 23 ein. Auf der anderen Seite der Grenze 56, in der Darstellung der Fig. 24 rechts, greifen erste Steckelemente 131 in die kombinierten Anschlüsse 29 ein. Die Niederspannungsanschlüsse 23 sind dabei auf einer Niederspannungsleiterkarte 49 angeordnet, die beispielsweise der Niederspannungsleiterkarte 49 entsprechend der Beschreibung zu den Fig. 4 und 9 entspricht. Die kombinierten Anschlüsse 29 sind auf einer Daten- und Kleinspannungsleiterkarte 48 angeordnet, wobei die Daten- und Kleinspannungsleiterkarte 48 auf einer anderen Höhe im zweiten Kanal 52 angeordnet ist als die Niederspannungsleiterkarte 49. Die Daten- und Kleinspannungsleiterkarte 48 entspricht dabei beispielsweise der Daten- und Kleinspannungsleiterkarte 48, wie sie im Zusammenhang mit den Fig. 4 und 9 beschrieben wurde.

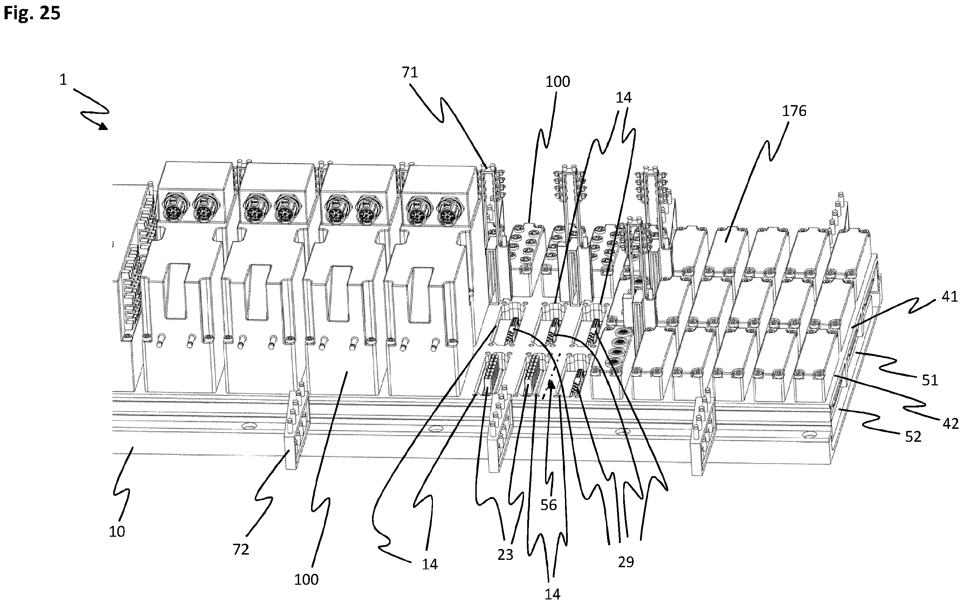

Fig. 25 zeigt eine isometrische Ansicht eines Ausschnittes des Schaltschranksystems 1 der Fig. 21 bis 24, bei der Funktionsmodule im Bereich der Grenze 56 vom Basismodul 10 entfernt wurden. Dadurch werden sechs Öffnungen 14 des Basismoduls 10 freigelegt, wobei jeweils drei Öffnungen 14 der ersten Reihe 41 und damit dem ersten Kanal 51 und jeweils drei Öffnungen 14 der zweiten Reihe 42 und damit dem zweiten Kanal 52 zugeordnet sind. Im Bereich zweier Öffnungen 14, die dem zweiten Kanal 52 zugeordnet und links von der Grenze 56 angeordnet sind, sind dadurch Niederspannungsanschlüsse 23 zugänglich. Im Bereich der weiteren Öffnungen 14, von denen drei dem ersten Kanal 51 zugeordnet sind und von denen eine dem zweiten Kanal 52 zugeordnet ist und die rechts von der Grenze 56 angeordnet ist, sind jeweils kombinierte Anschlüsse 29 zugänglich. Das in Fig. 25 dargestellte Entfernen einzelner Funktionsmodule kann beispielsweise auch während des Betriebs des Schaltschranksystems 1 erfolgen. Dies ermöglicht, Funktionsmodule 100 zu warten und/oder auszutauschen.

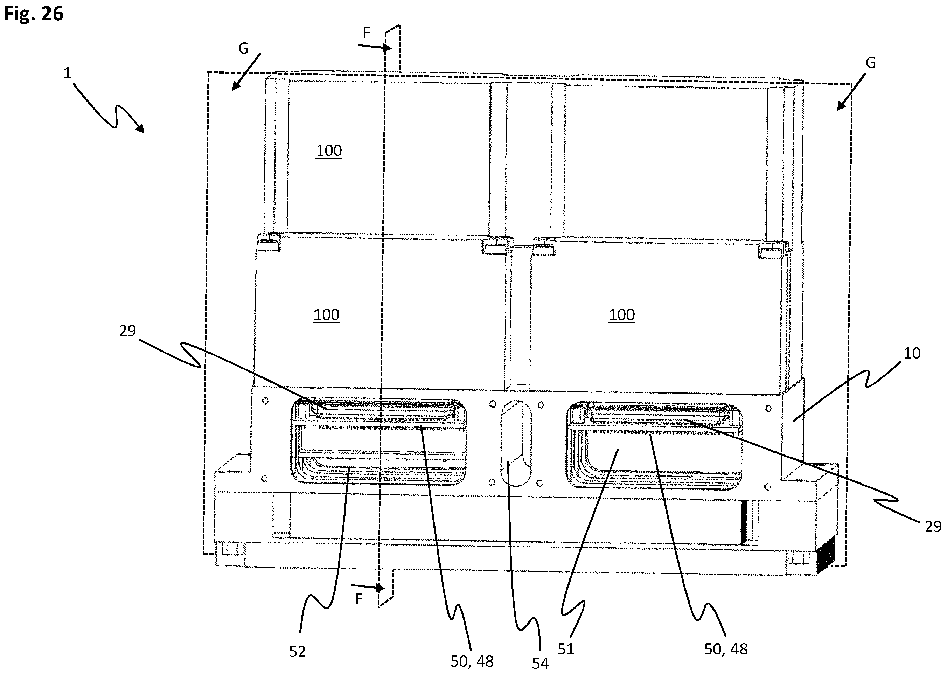

Fig. 26 zeigt einen Querschnitt durch ein weiteres Schaltschranksystem 1, bestehend aus einem Basismodul 10 und drei Funktionsmodulen 100. Das Basismodul 10 entspricht dabei dem Basismodul 10 der Fig. 3 oder der Fig. 20 sofern im Folgenden keine Unterschiede beschrieben sind. Das Basismodul 10 weist ebenso wie das Basismodul 10 der Fig. 3 keinen dritten Kanal auf. Eine Schnittebene des Querschnitts ist dabei außerhalb der Funktionsmodule 100 angeordnet, so dass nur das Basismodul 10 im Querschnitt geöffnet ist. Das Basismodul weist zwei Kanäle, also einen ersten Kanal 51 und einen zweiten Kanal 52 auf, wie beispielsweise für Fig. 3 und 4 beschrieben. Sowohl im ersten Kanal 51 als auch im zweiten Kanal 52 weist das Basismodul 10 eine Daten- und Kleinspannungsleiterkarte 48 und jeweils einen auf der Daten- und Kleinspannungsleiterkarte 48 angeordneten kombinierten Anschluss 29 auf. Die direkt hinter der Schnittebene liegenden Funktionsmodule 100 greifen in die kombinierten Anschlüsse 29 ein und überdecken jeweils den ersten Kanal 51 oder den zweiten Kanal 52. An anderer Stelle kann im zweiten Kanal 52 eine Niederspannungsleiterkarte vorgesehen sein, die wie in den Fig. 4, 6, 8 und 20 beschrieben ausgestaltet sein kann. Hinter den direkt nach der Schnittebene angeordneten Funktionsmodulen 100 ist ein Funktionsmodul 100 angeordnet, welches den ersten Kanal 51 und den zweiten Kanal 52 überdeckt.

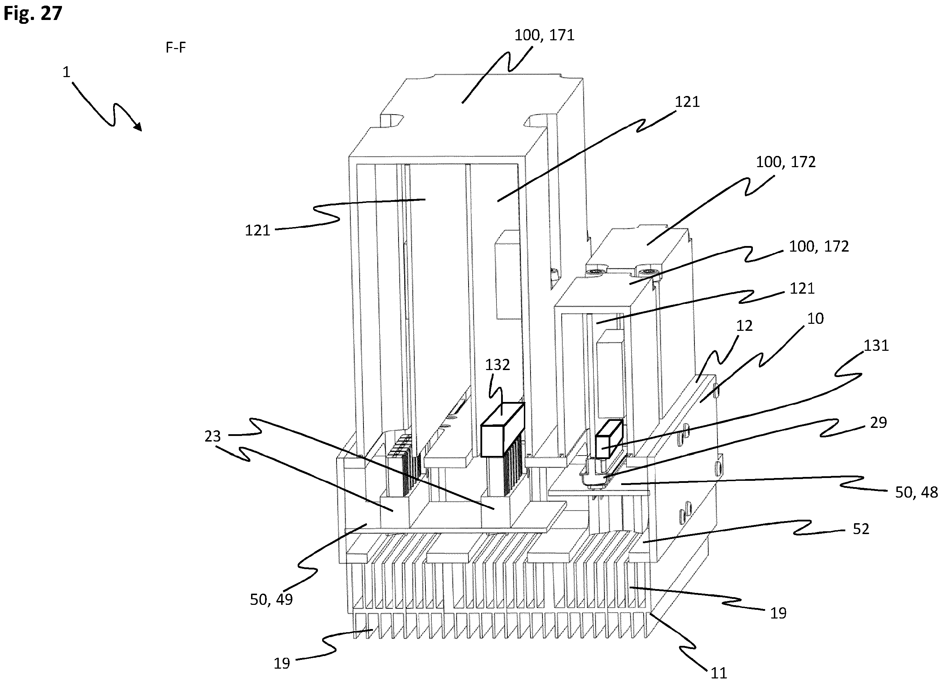

Fig. 27 zeigt einen Querschnitt durch das Schaltschranksystem 1 der Fig. 26 an der mit F bezeichneten Schnittebene. Modulleiterkarten 121 eines ersten Funktionsmoduls 171 weisen eine elektronische Schaltung auf, die Niederspannung benötigt. Folglich greift im Bereich des ersten Funktionsmoduls 171 ein Modulanschlusselement, welches in Form eines zweiten Steckelements 132 ausgestaltet ist, in einen der Niederspannungsanschlüsse 23 ein. Die in einem zweiten Funktionsmodul 172 auf einer Modulleiterkarte 121 verbaute elektronische Schaltung benötigt keine Niederspannung. Ferner ist das zweite Funktionsmodul 172 nur oberhalb des zweiten Kanals 52 angeordnet. Das zweite Funktionsmodul 172 weist ein erstes Steckelement 131 auf, welches in einen kombinierten Anschluss 29 der Daten- und Kleinspannungsleiterkarte 48 eingreift.

Ebenso in Fig. 27 dargestellt sind Kühlelemente 19, die am Gehäuse 11 des Basismoduls 10 in der Form von Kühlrippen angeordnet sind und einen Wärmeaustausch mit der Umgebung ermöglichen.

Die Modulleiterkarten 121 sind senkrecht zur ersten Gehäuseseite 12 angeordnet. Es sind jedoch auch andere Anordnungen der Modulleiterkarten 121 möglich. Die Daten- und Kleinspannungsleiterkarte 48 sowie die Niederspannungsleiterkarte 49 ist jeweils parallel zur ersten Gehäuseseite 12 angeordnet.

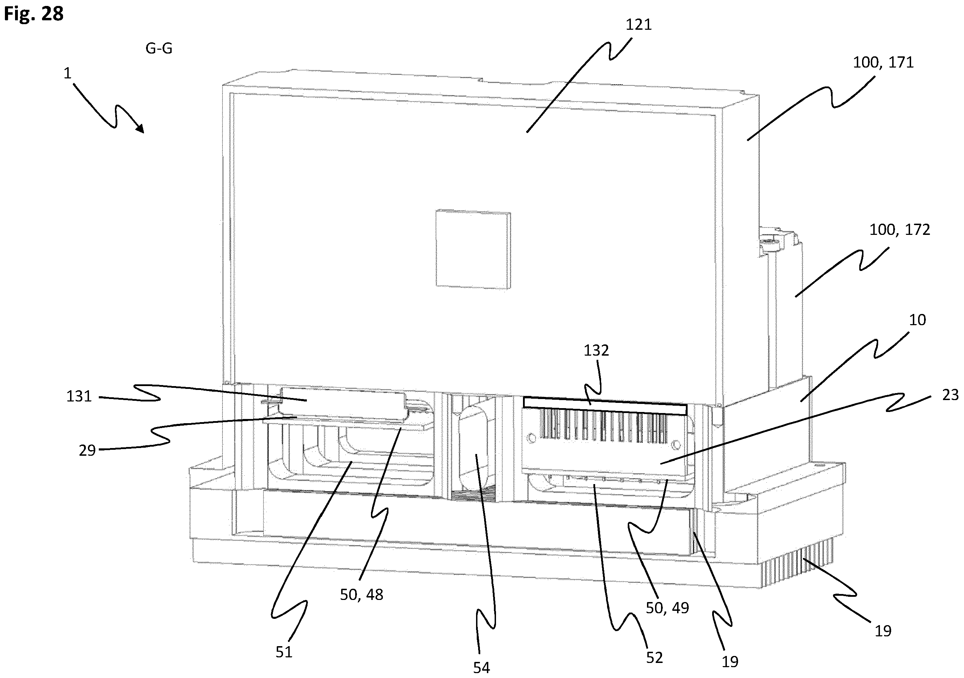

Fig. 28 zeigt einen Querschnitt durch das Schaltschranksystem 1 der Fig. 26 und 27, wobei die Schnittebene durch das erste Funktionsmodul 171 an der in Fig. 26 mit G bezeichneten Schnittebene gelegt ist. Ein erstes Steckelement 131 greift in den kombinierten Anschluss 29 ein. Das in Fig. 27 dargestellte zweite Steckelement 132 dient zum Eingriff in den Niederspannungsanschluss 23.

In den Fig. 26 bis 28 ist also ein Schaltschranksystem 1 gezeigt, welches im zweiten Kanal 52 analog zu der Darstellung in den Fig. 20 bis 25 bis zu einer Grenze Niederspannungsanschlüsse 23 auf einer Niederspannungsleiterkarte 49 und ab der Grenze kombinierte Anschlüsse 29 auf einer Daten- und Kleinspannungsleiterkarte 48 aufweist.

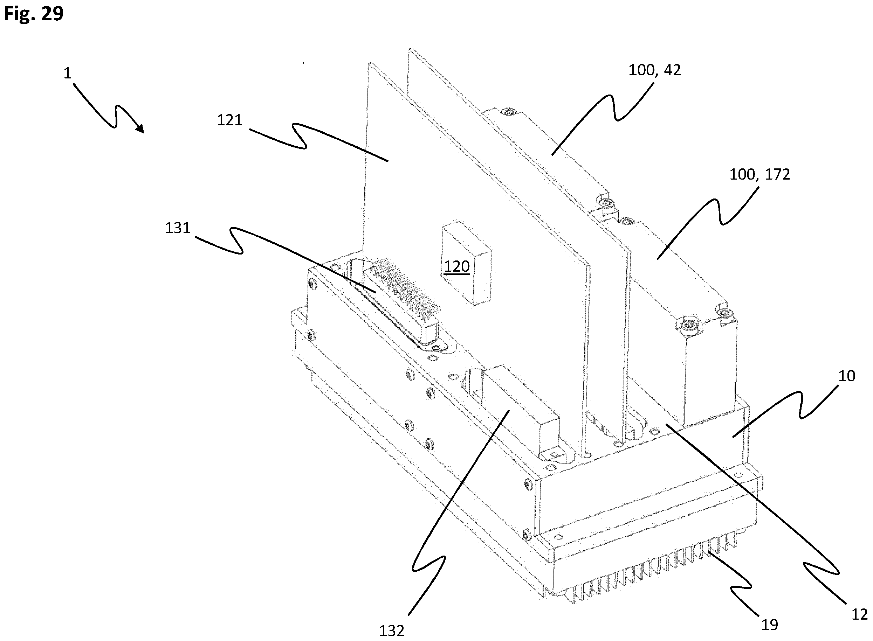

Fig. 29 zeigt eine gedrehte isometrische Ansicht des Schaltschranksystems 1 der Fig. 26 bis 28, bei dem das Modulgehäuse des ersten Funktionsmoduls entfernt wurde. Die elektronische Schaltung 120 auf der Modulleiterkarte 121 weist ein erstes Steckelement 131 zum Eingriff in den kombinierten Anschluss und ein zweites Steckelement 132 zum Eingriff in den Niederspannungsanschluss auf. Der kombinierte Anschluss und der Niederspannungsanschluss sind dabei durch das erste Steckelement 131 beziehungsweise das zweite Steckelement 132 verdeckt. Die Modulleiterkarte 121 ist senkrecht zur ersten Gehäuseseite 12 angeordnet. Es sind jedoch auch andere Anordnungen der Modulleiterkarten 121 möglich. Das erste Funktionsmodul weist dabei zwei Modulleiterkarten 121 auf, es ist jedoch auch eine andere Anzahl von Modulleiterkarten 121 denkbar.

Es kann vorgesehen sein, dass die in den Fig. 20 bis 29 gezeigten Basismodule Dichtungen analog zu den in Fig. 13 und 16 gezeigten Dichtungen aufweist. Ferner kann vorgesehen sein, dass die Basismodule eine Sicherheitsschaltung analog zu Fig. 9 beziehungsweise eine Überwachungsschaltung analog zu Fig. 10 aufweisen.

### Bezugszeichenliste

- 1: Schaltschranksystem
- 2: gemeinsames Gehäuse
- 3: Modulzwischenraum

- 10: Basismodul
- 11: Gehäuse
- 12: erste Gehäuseseite
- 13: weitere Gehäuseseite
- 14: Öffnung
- 15: Steckplatz
- 16: Dichtung
- 17: Zwischenraum
- 18: Erdungsschiene
- 19: Kühlelement

- 20: Anschlusselement
- 21: Datenanschluss
- 22: Kleinspannungsanschluss
- 23: Niederspannungsanschluss
- 24: Gehäuseanschluss
- 25: Gehäusedatenanschluss
- 26: Gehäusekleinspannungsanschluss
- 27: Gehäuseniederspannungsanschluss
- 28: Druckausgleichsmembran
- 29: kombinierter Anschluss

- 31: Datenleitung
- 32: Kleinspannungsleitung
- 33: Niederspannungsleitung
- 35: Sicherheitsschaltung
- 36: Sicherheitsleitung
- 37: Überwachungsschaltung
- 38: Schalter
- 39: Überwachungssignalleitung

- 41: erste Reihe
- 42: zweite Reihe
- 43: dritte Reihe
- 44: Gewindeloch
- 48: Daten- und Kleinspannungsleiterkarte
- 49: Niederspannungsleiterkarte

- 50: Leiterkarte
- 51: erster Kanal
- 52: zweiter Kanal
- 53: dritter Kanal
- 54: erste Trennwand
- 55: zweite Trennwand
- 56: Grenze

- 60: Steckverbinder
- 61: erster Kontakt
- 62: zweiter Kontakt
- 63: dritter Kontakt
- 64: vierter Kontakt
- 65: fünfter Kontakt
- 66: sechster Kontakt
- 67: siebter Kontakt

- 71: erstes Kabelführungselement
- 72: zweites Kabelführungselement

- 100: Funktionsmodul

- 110: Modulgehäuse
- 111: Modulgehäuseseite
- 112: weitere Modulgehäuseseite
- 114: Öffnung

- 120: elektronische Schaltung
- 121: Modulleiterkarte
- 123: Regelelement
- 124: Peripherieanschlusselement
- 130: Modulanschlusselement
- 131: erstes Steckelement
- 132: zweites Steckelement
- 150: Durchgangslöcher
- 151: Ausnehmungen
- 152: Schraube

- 171: erstes Funktionsmodul
- 172: zweites Funktionsmodul
- 173: drittes Funktionsmodul
- 174: viertes Funktionsmodul
- 175: fünftes Funktionsmodul
- 176: Deckel

## Patentansprüche

1. Basismodul (10) für ein Schaltschranksystem, wobei das Basismodul (10) ein Gehäuse (11) mit einer erste Gehäuseseite (12) und weiteren Gehäuseseiten (13) aufweist, wobei die erste Gehäuseseite (12) ein Raster von Öffnungen (14) aufweist, wobei das Gehäuse (11) Anschlusselemente (20) für Funktionsmodule (100) aufweist, wobei die Anschlusselemente (20) jeweils im Bereich der Öffnungen (14) der erste Gehäuseseite (12) angeordnet sind, wobei die Anschlusselemente (20) Datenanschlüsse (21), Kleinspannungsanschlüsse (22) und Niederspannungsanschlüsse (23) umfassen, wobei die Datenanschlüsse (21) mittels einer Datenleitung (31) des Basismoduls (10) miteinander verbunden sind, wobei ein Feldbusanschluss für die Datenleitung (31) bereitgestellt werden kann, wobei die Datenleitung (31) innerhalb des Gehäuses (11) angeordnet ist, wobei eine Kleinspannungsleitung (32) und eine Niederspannungsleitung (33) innerhalb des Gehäuses (11) angeordnet sind, wobei die Kleinspannungsleitung (32) mit den Kleinspannungsanschlüssen (22) verbunden ist und die Niederspannungsleitung (33) mit den Niederspannungsanschlüssen (23) verbunden ist, wobei über die Kleinspannungsleitung (32) und die Kleinspannungsanschlüsse (22) eine Kleinspannung bis zu 50 Volt Wechselspannung und/oder 120 Volt Gleichspannung bereitgestellt werden kann und über die Niederspannungsleitung (33) und die Niederspannungsanschlüsse (23) eine Niederspannung oberhalb der Kleinspannung und bis zu 1000 Volt Wechselspannung und/oder 1500 Volt Gleichspannung bereitgestellt werden kann, **gekennzeichnet dadurch, dass** das Gehäuse (11) zwei Kanäle (51, 52) aufweist, wobei die Datenanschlüsse (21) und die Kleinspannungsanschlüsse (22) in einem ersten Kanal (51) und die Niederspannungsanschlüsse (23) in einem zweiten Kanal (52) angeordnet sind, wobei zwischen dem ersten Kanal (51) und dem zweiten Kanal (52) eine erste Trennwand (54) angeordnet ist.

2. Basismodul (10) nach Anspruch 1, wobei jeweils eine Mehrzahl von Datenanschlüssen (21) und eine Mehrzahl von Kleinspannungsanschlüssen (22) auf einer Daten- und Kleinspannungsleiterkarte (48) angeordnet sind, wobei eine Mehrzahl von Niederspannungsanschlüssen (23) auf einer Niederspannungsleiterkarte (49) angeordnet ist, wobei die Datenleitung (31) und die Kleinspannungsleitung (32) durch die Daten- und Kleinspannungsleiterkarte (48) bereitgestellt werden, wobei die Niederspannungsleitung (33) durch die Niederspannungsleiterkarte (49) bereitgestellt wird.

3. Basismodul (10) nach Anspruch 2, wobei die Daten- und Kleinspannungsleiterkarte (48) im ersten Kanal (51) angeordnet ist, wobei die Niederspannungsleiterkarte (49) im zweiten Kanal (52) angeordnet ist.

4. Basismodul (10) nach einem der Ansprüche 1 bis 3, wobei das Gehäuse (11) einen dritten Kanal (53) aufweist, wobei eine zweite Trennwand (55) zwischen dem dritten Kanal (53) und dem ersten Kanal (51) oder dem zweiten Kanal (52) angeordnet ist, und wobei Kühlluft über den dritten Kanal (53) geführt werden kann

5. Basismodul (10) nach einem der Ansprüche 1 bis 4, wobei der Datenanschluss (21) und der Kleinspannungsanschluss (22) jeweils als kombiniertes Anschlusselement (20) ausgestaltet sind und einer ersten Reihe (41) von Öffnungen (14) der ersten Gehäuseseite (12) zugeordnet sind.

6. Basismodul (10) nach einem der Ansprüche 1 bis 5, wobei vier Gewindelöcher (44) pro Öffnung (14) zur Befestigung eines Funktionsmoduls (100) an der ersten Gehäuseseite (12) angeordnet sind, wobei die Gewindelöcher (44) das Gehäuse (11) nicht durchbrechen, wobei das Funktionsmodul (100) die Öffnung (14) staub- und flüssigkeitsdicht verschließen kann.

7. Basismodul (10) nach einem der Ansprüche 1 bis 6, wobei die Niederspannungsanschlüsse (23) jeweils einen siebenpoligen Steckverbinder (60) aufweisen, wobei die siebenpoligen Steckverbinder (60) jeweils einen ersten Kontakt (61), einen zweiten Kontakt (62) und einen dritten Kontakt (63) für jeweils eine Wechselstromphase, einen vierten Kontakt (64) für einen Wechselstromneutralleiter, einen fünften Kontakt (65) für einen Schutzleiter, sowie einen sechsten Kontakt (66) und einen siebten Kontakt (67) für eine Gleichspannung aufweisen.

8. Basismodul (10) nach Anspruch 7, wobei der erste Kontakt (61), der zweite Kontakt (62), der dritte Kontakt (63), der vierte Kontakt (64), der fünfte Kontakt (65), der sechste Kontakt (66) und der siebte Kontakt (67) in dieser Reihenfolge in einer Reihe angeordnet sind.

9. Basismodul (10) nach einem der Ansprüche 1 bis 8, wobei die Datenanschlüsse (21) und Kleinspannungsanschlüsse (22) unterhalb der Öffnungen (14) der ersten Gehäuseseite (12) innerhalb des Gehäuses (11) angeordnet sind.

10. Basismodul (10) nach einem der Ansprüche 1 bis 9, ferner aufweisend eine Überwachungsschaltung (37), wobei die Überwachungsschaltung (37) zur Ermittlung mehrerer Umgebungsparameter eingerichtet ist, wobei die Umgebungsparameter eine Neigung und eine Schwingung und eine Temperatur und eine Luftfeuchtigkeit umfassen, und ferner zur Abschaltung eines der Kleinspannungsanschlüsse (22) und/oder eines der Niederspannungsanschlüsse (23) eingerichtet ist, sofern einer der Umgebungsparameter außerhalb eines vorbestimmten Wertebereichs liegt.

11. Basismodul (10) nach einem der Ansprüche 1 bis 10, wobei die Datenanschlüsse (21) und die Kleinspannungsanschlüsse (22) ferner im zweiten Kanal (52) angeordnet sind.

12. Schaltschranksystem (1) aus einem Basismodul (10) nach einem der Ansprüche 1 bis 11 und mindestens einem Funktionsmodul (100), wobei das Funktionsmodul (100) an der erste Gehäuseseite (12) angeordnet werden kann, wobei das Funktionsmodul (100) ein Modulgehäuse (110) und zumindest ein Modulanschlusselement (130) aufweist, wobei das Modulanschlusselement (130) in ein Anschlusselement (20) für Funktionsmodule (100) des Basismoduls (10) eingreifen kann, insbesondere in die Datenanschlüsse (21) und die Kleinspannungsanschlüsse (22), und wobei das Funktionsmodul (100) mindestens eine der Öffnungen (14) des Gehäuses (11) abdeckt.

13. Schaltschranksystem (1) nach Anspruch 12, wobei zumindest ein Modulanschlusselement (130) des Funktionsmoduls (100) in die Niederspannungsanschlüsse (23) eingreifen kann.

14. Schaltschranksystem (1) nach einem der Ansprüche 12 oder 13, wobei das Schaltschranksystem (1) mehrere Funktionsmodule (100) aufweist, die am Basismodul (10) befestigt sind, wobei die Öffnungen (14) durch die Funktionsmodule (100) abgedeckt sind oder durch die Funktionsmodule (100) und Deckel (176) abgedeckt sind und wobei das Schaltschranksystem (1) aus Basismodul (10) und Funktionsmodulen (100) staubdicht und flüssigkeitsdicht ist.

15. Schaltschranksystem (1) nach einem der Ansprüche 12 bis 14, wobei das Modulgehäuse (110) eine erste Modulgehäuseseite (111) und weitere Modulgehäuseseiten (112) aufweist, wobei die erste Modulgehäuseseite (111) eine Modulgehäuseöffnung (114) aufweist, wobei die erste Modulgehäuseseite (111) eben ist.

## Claims

1. Base module (10) for a switch cabinet system, wherein the base module (10) has a housing (11) with a first housing side (12) and further housing sides (13), wherein the first housing side (12) has a grid of openings (14), wherein the housing (11) has connection elements (20) for functional modules (100), wherein the connection elements (20) are each arranged in the region of the openings (14) of the first housing side (12), wherein the connection elements (20) comprise data connections (21), extra-low-voltage connections (22) and low-voltage connections (23), wherein the data connections (21) are connected to one another by means of a data line (31) of the base module (10), wherein a field-bus connection for the data line (31) can be provided, wherein the data line (31) is arranged inside the housing (11), wherein an extra-low-voltage line (32) and a low-voltage line (33) are arranged inside the housing (11), wherein the extra-low-voltage line (32) is connected to the extra-low-voltage connections (22), and the low-voltage line (33) is connected to the low-voltage connections (23), wherein an extra-low-voltage of up to 50 V AC and/or 120 V DC can be provided via the extra-low-voltage line (32) and the extra-low-voltage connections (22), and a low-voltage above the extra-low-voltage and up to 1000 V AC and/or 1500 V DC can be provided via the low-voltage line (33) and the low-voltage connections (23), **characterized in that** the housing (11) has two channels (51, 52), wherein the data connections (21) and the extra-low-voltage connections (22) are arranged in a first channel (51), and the low-voltage connections (23) are arranged in a second channel (52), wherein a first partition (54) is arranged between the first channel (51) and the second channel (52).

2. Base module (10) according to Claim 1, wherein a plurality of data connections (21) and a plurality of extra-low-voltage connections (22) are each arranged on a data and extra-low-voltage circuit board (48), wherein a plurality of low-voltage connections (23) is arranged on a low-voltage circuit board (49), wherein the data line (31) and the extra-low-voltage line (32) are provided by the data and extra-low-voltage circuit board (48), wherein the low-voltage line (33) is provided by the low-voltage circuit board (49).

3. Base module (10) according to Claim 2, wherein the data and extra-low-voltage circuit board (48) is arranged in the first channel (51), wherein the low-voltage circuit board (49) is arranged in the second channel (52) .

4. Base module (10) according to one of Claims 1 to 3, wherein the housing (11) has a third channel (53), wherein a second partition (55) is arranged between the third channel (53) and the first channel (51) or the second channel (52), and wherein cooling air can be guided over the third channel (53).

5. Base module (10) according to one of Claims 1 to 4, wherein the data connection (21) and the extra-low-voltage connection (22) are each configured as a combined connection element (20) and are assigned to a first row (41) of openings (14) of the first housing side (12).

6. Base module (10) according to one of Claims 1 to 5, wherein four threaded holes (44) per opening (14) are arranged for fixing a functional module (100) on the first housing side (12), wherein the threaded holes (44) do not penetrate the housing (11), wherein the functional module (100) can close the opening (14) in a dust-tight and liquid-tight manner.

7. Base module (10) according to one of Claims 1 to 6, wherein the low-voltage connections (23) each have a seven-pin connector (60), wherein the seven-pin connectors (60) each have a first contact (61), a second contact (62) and a third contact (63) for a respective AC phase, a fourth contact (64) for an AC neutral conductor, a fifth contact (65) for a protective conductor, and a sixth contact (66) and a seventh contact (67) for a DC voltage.

8. Base module (10) according to Claim 7, wherein the first contact (61), the second contact (62), the third contact (63), the fourth contact (64), the fifth contact (65), the sixth contact (66) and the seventh contact (67) are arranged in this order in a row.

9. Base module (10) according to one of Claims 1 to 8, wherein the data connections (21) and extra-low-voltage connections (22) are arranged below the openings (14) of the first housing side (12) within the housing (11).

10. Base module (10) according to one of Claims 1 to 9, further having a monitoring circuit (37), wherein the monitoring circuit (37) is set up to determine a plurality of environmental parameters, wherein the environmental parameters comprise an inclination and a vibration and a temperature and an atmospheric humidity, and is further set up to disconnect one of the extra-low-voltage connections (22) and/or one of the low-voltage connections (23) if one of the environmental parameters lies outside a predetermined value range.

11. Base module (10) according to one of Claims 1 to 10, wherein the data connections (21) and the extra-low-voltage connections (22) are also arranged in the second channel (52).

12. Switch cabinet system (1) comprising a base module (10) according to one of Claims 1 to 11 and at least one functional module (100), wherein the functional module (100) can be arranged on the first housing side (12), wherein the functional module (100) has a module housing (110) and at least one module connection element (130), wherein the module connection element (130) can engage in a connection element (20) for functional modules (100) of the base module (10), in particular in the data connections (21) and the extra-low-voltage connections (22), and wherein the functional module (100) covers at least one of the openings (14) of the housing (11).

13. Switch cabinet system (1) according to Claim 12, wherein at least one module connection element (130) of the functional module (100) can engage in the low-voltage connections (23).

14. Switch cabinet system (1) according to either of Claims 12 and 13, wherein the switch cabinet system (1) has a plurality of functional modules (100) which are fixed to the base module (10), wherein the openings (14) are covered by the functional modules (100) or are covered by the functional modules (100) and covers (176), and wherein the switch cabinet system (1) comprising base module (10) and functional modules (100) is dust-tight and liquid-tight.

15. Switch cabinet system (1) according to one of Claims 12 to 14, wherein the module housing (110) has a first module housing side (111) and further module housing sides (112), wherein the first module housing side (111) has a module housing opening (114), wherein the first module housing side (111) is flat.

## Revendications

1. Module de base (10) pour un système d'armoire de distribution, le module de base (10) possédant un boîtier (11) ayant un premier côté de boîtier (12) et des côtés de boîtier supplémentaires (13), le premier côté de boîtier (12) possédant une grille d'ouvertures (14), le boîtier (11) possédant des éléments de raccordement (20) pour des modules fonctionnels (100), les éléments de raccordement (20) étant respectivement disposés dans la zone des ouvertures (14) du premier côté de boîtier (12), les éléments de raccordement (20) comportant des ports de données (21), des raccordements à très basse tension (22) et des raccordements à basse tension (23), les ports de données (21) étant reliés entre eux au moyen d'une ligne de données (31) du module de base (10), un port de bus de terrain pouvant être fourni pour la ligne de données (31), la ligne de données (31) étant disposée à l'intérieur du boîtier (11), une ligne à très basse tension (32) et une ligne à basse tension (33) étant disposées à l'intérieur du boîtier (11), la ligne à très basse tension (32) étant reliée aux raccordements à très basse tension (22) et la ligne à basse tension (33) étant reliée aux raccordements à basse tension (23), une très basse tension jusqu'à 50 volts de tension alternative et/ou de 120 volts de tension continue pouvant être mise à disposition par le biais de la ligne à très basse tension (32) et des raccordements à très basse tension (22) et une basse tension supérieure à la très basse tension et jusqu'à 1000 volts de tension alternative et/ou 1500 volts de tension continue pouvant être mise à disposition par le biais de la ligne à basse tension (33) et des raccordements à basse tension (23), **caractérisé en ce que** le boîtier (11) possède deux conduits (51, 52), les ports de données (21) et les raccordements à très basse tension (22) étant disposés dans un premier conduit (51) et les raccordements à basse tension (23) étant disposés dans un deuxième conduit (52), une première paroi de séparation (54) étant disposée entre le premier conduit (51) et le deuxième conduit (52).

2. Module de base (10) selon la revendication 1, une pluralité de ports de données (21) et une pluralité de raccordements à très basse tension (22) étant respectivement disposés sur une carte de circuit imprimé de données et de très basse tension (48), une pluralité de raccordements à basse tension (23) étant disposés sur une carte de circuit imprimé de basse tension (49), la ligne de données (31) et la ligne à très basse tension (32) étant mises à disposition par la carte de circuit imprimé de données et de très basse tension (48), la ligne à basse tension (33) étant mise à disposition par la carte de circuit imprimé de basse tension (49).

3. Module de base (10) selon la revendication 2, la carte de circuit imprimé de données et de très basse tension (48) étant disposée dans le premier conduit (51), la carte de circuit imprimé de basse tension (49) étant disposée dans le deuxième conduit (52).

4. Module de base (10) selon l'une des revendications 1 à 3, le boîtier (11) possédant un troisième conduit (53), une deuxième paroi de séparation (55) étant disposée entre le troisième conduit (53) et le premier conduit (51) ou le deuxième conduit (52), et de l'air de refroidissement pouvant être guidé par le biais du troisième conduit (53).

5. Module de base (10) selon l'une des revendications 1 à 4, le port de données (21) et le raccordement à très basse tension (22) étant respectivement configurés comme un élément de raccordement combiné (20) et étant associés à une première rangée (41) d'ouvertures (14) du premier côté de boîtier (12).

6. Module de base (10) selon l'une des revendications 1 à 5, quatre trous taraudés (44) par ouverture (14) servant à la fixation d'un module fonctionnel (100) étant disposés sur le premier côté de boîtier (12), les trous taraudés (44) ne transperçant pas le boîtier (11), le module fonctionnel (100) pouvant fermer l'ouverture (14) de manière étanche à la poussière et aux liquides.

7. Module de base (10) selon l'une des revendications 1 à 6, les raccordements à basse tension (23) possédant respectivement un connecteur à enficher à sept broches (60), les connecteurs à enficher à sept broches (60) possédant respectivement un premier contact (61), un deuxième contact (62) et un troisième contact (63) respectivement pour une phase de courant alternatif, un quatrième contact (64) pour un conducteur neutre de courant alternatif, un cinquième contact (65) pour un conducteur de protection, ainsi qu'un sixième contact (66) et un septième contact (67) pour une tension continue.

8. Module de base (10) selon la revendication 7, le premier contact (61), le deuxième contact (62), le troisième contact (63), le quatrième contact (64), le cinquième contact (65), le sixième contact (66) et le septième contact (67) étant disposés en une ligne dans cet ordre.

9. Module de base (10) selon l'une des revendications 1 à 8, les ports de données (21) et les raccordements à très basse tension (22) étant disposés au-dessous des ouvertures (14) du premier côté de boîtier (12) à l'intérieur du boîtier (11).

10. Module de base (10) selon l'une des revendications 1 à 9, possédant en outre un circuit de surveillance (37), le circuit de surveillance (37) étant conçu pour déterminer plusieurs paramètres d'environnement, les paramètres d'environnement comprenant une inclinaison et une oscillation et une température et un taux d'humidité de l'air, et étant en outre conçu pour mettre hors circuit l'un des raccordements à très basse tension (22) et/ou l'un des raccordements à basse tension (23), dans la mesure où l'un des paramètres d'environnement se trouve en-dehors d'une plage de valeurs prédéterminée.

11. Module de base (10) selon l'une des revendications 1 à 10, les ports de données (21) et les raccordements à très basse tension (22) étant en outre disposés dans le deuxième conduit (52).

12. Système d'armoire de distribution (1) composé d'un module de base (10) selon l'une des revendications 1 à 11 et d'au moins un module fonctionnel (100), le module fonctionnel (100) pouvant être disposé au niveau du premier côté de boîtier (12), le module fonctionnel (100) possédant un boîtier de module (110) et au moins un élément de raccordement de module (130), l'élément de raccordement de module (130) pouvant venir en prise dans un élément de raccordement (20) pour modules fonctionnels (100) du module de base (10), notamment dans les ports de données (21) et les raccordements à très basse tension (22), et le module fonctionnel (100) recouvrant au moins l'une des ouvertures (14) du boîtier (11).

13. Système d'armoire de distribution (1) selon la revendication 12, au moins un élément de raccordement de module (130) du module fonctionnel (100) pouvant venir en prise dans les raccordements à basse tension (23).

14. Système d'armoire de distribution (1) selon l'une des revendications 12 et 13, le système d'armoire de distribution (1) possédant plusieurs modules fonctionnels (100) qui sont fixés au module de base (10), les ouvertures (14) étant recouvertes par les modules fonctionnels (100) ou étant recouvertes par les modules fonctionnels (100) et des couvercles (176) et le système d'armoire de distribution (1) composé du module de base (10) et des modules fonctionnels (100) étant étanche à la poussière et étanche aux liquides.

15. Système d'armoire de distribution (1) selon l'une des revendications 12 à 14, le boîtier de module (110) possédant un premier côté de boîtier de module (111) et des côtés de boîtier de module supplémentaires (112), le premier côté de boîtier de module (111) possédant une ouverture de boîtier de module (114), le premier côté de boîtier de module (111) étant plan.
